(19) Europäisches Patentamt / European Patent Office / Office européen des brevets

(11) EP 3 468 979 B1

# (12) EUROPEAN PATENT SPECIFICATION

(45) Date of publication and mention of the grant of the patent:
**15.09.2021 Bulletin 2021/37**

(21) Application number: **17731812.8**

(22) Date of filing: **01.06.2017**

(51) Int Cl.:
***C07F 7/08*** *(2006.01)* ***C07F 7/22*** *(2006.01)*
***H01L 51/50*** *(2006.01)* ***H01L 51/00*** *(2006.01)*
***C09K 11/66*** *(2006.01)*

(86) International application number:
**PCT/EP2017/063274**

(87) International publication number:
**WO 2017/211669 (14.12.2017 Gazette 2017/50)**

## (54) MOLECULAR WHITE-LIGHT EMITTER

MOLEKULARER WEISSLICHTEMITTER

ÉMETTEUR MOLÉCULAIRE DE LUMIÈRE BLANCHE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.06.2016 EP 16174060**

(43) Date of publication of application:
**17.04.2019 Bulletin 2019/16**

(73) Proprietor: **Philipps-Universität Marburg**
**35032 Marburg (DE)**

(72) Inventors:
- **DEHNEN, Stefanie**
  **76135 Karlsruhe (DE)**
- **CHATTERJEE, Sangam**
  **35037 Marburg (DE)**
- **EUSSNER, Jens Peter**
  **01097 Dresden (DE)**
- **ROSEMANN, Nils W.**
  **71229 Leonberg (DE)**
- **VOLZ, Kerstin**
  **35232 Dautphetal (DE)**
- **BEYER, Andreas**
  **35094 Großfelden (DE)**

(74) Representative: **Stumpf, Peter**
**c/o TransMIT GmbH**
**Kerkrader Strasse 3**
**35394 Gießen (DE)**

(56) References cited:
**WO-A1-2009/099568 WO-A1-2009/099569**

- **HERZOG U ET AL: "New chalcogen derivatives of silicon possessing adamantane and noradamantane structures", JOURNAL OF ORGANOMETALLIC CHEMIS, ELSEVIER-SEQUOIA S.A. LAUSANNE, CH, vol. 628, no. 2, 26 May 2001 (2001-05-26), pages 133-143, XP004242209, ISSN: 0022-328X, DOI: 10.1016/S0022-328X(01)00782-3**
- **WATARU ANDO ET AL: "Chemistry of Germanium-Characteristics and Similarity as a Group 14 Element. Silicon and Germanium Chalcogenides with Nor- and Bisnor-adamantane Structures.", NIPPON KAGAKU KAISHI: JOURNAL OF THE CHEMICAL SOCIETY OF JAPAN., no. 3, 1 January 1994 (1994-01-01), pages 214-223, XP55400537, JP ISSN: 0369-4577, DOI: 10.1246/nikkashi.1994.214**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 468 979 B1

## Description

### Field of the invention

The invention belongs to the field of converting infrared light into visible light.

### Background of the technology

The impact of well-managed light on our everyday life is immeasurable. The light-emitting diode (LED) is one of the most prominent developments since the invention of incandescent lightbulbs in the late 1800s. The latter dissipate most energy in the infrared as heat, whereas typical white LEDs cover only the visible spectrum. Most prominent examples of white-light LEDs are based on galliumnitride. Their narrow-band ultraviolet (UV) emission is converted into visible light by applying phosphors. This cold light has tremendous advantages with respect to energy efficiency. Other concepts pursued for efficient white-light generation include the combination of red, green, and blue emitters, which is currently the path of choice for organic LEDs. All types of LEDs excel due to their virtually Lambertian emission patterns that are highly desirable for applications like active displays that require large viewing angles. However, this poses challenges in targeted illumination and projection of light due to the associated large etendue $G = A\Omega$, where A is the source area and $\Omega$ is the solid angle of emission. Ideally, the etendue remains constant throughout an entire optical system where light undergoes perfect reflections or refractions. It can increase - for example, when impinging on a diffusor - but cannot be decreased without loss in radiance. This renders low-etendue sources extremely desirable for devices requiring high spatial resolution like microscopes or for applications with high throughput, such as projection systems. Other concepts of white-light generation by monochromatic sources besides phosphors rely on nonlinear effects that provide very broadband supercontinua and are widely used in many scientific applications. These are often referred to as brilliant sources. They generally feature small, point-source-like emission areas due to the tightly focused short-pulsed driving lasers that are used to overcome the vast peak electric field strength required to invoke the extremely nonlinear effects such as soliton formation. Hence, the related challenges, such as the system size, price, and energy requirements, restrict the use of supercontinuum sources to scientific laboratory use and the medical sector - for example, in coherent anti-Stokes Raman scattering or optical coherence tomography, as well as for defense and security applications.

Document WO 2009/099568 A1 reveals fluorescent diamondoid materials which emit light upon energizing, the emitted light generally being in the visible range of the electromagnetic spectrum. An application of these materials is in indoor lighting where the materials can be used to produce white light by using the material as a fluorescent medium for a UV light source. The fluorescent diamondoid materials as defined in WO 2009/099568 A1 only comprise wholly organic materials, i. e. the diamondoid core structures of these materials are completely composed of carbon atoms so that the fluorescent diamandoid materials within WO 2009/099568 A1 are confined to adamantane, diamantane, triamantane, etc.

Tailored light sources have greatly advanced technological and scientific progress by optimizing the emission spectrum or color and the emission characteristics. Well known are, e.g., white-light fiber laser. But all known devices only transform either the light emitted by expensive high-power lasers into directional white light or high energy UV emission of blue LEDs into omnidirectional white light. There is no material/device known within the state of the art, which can transform the light emitted by low-cost, compact laser diodes or other low-energetic monochromatic light sources into white-light.

### Content of the invention

The invention therefore provides such a new material/device transforming the light emitted by low-cost, compact laser diodes or other monochromatic light sources into white-light.

We demonstrate an efficient spectrally broadband and highly directional warm-white-light emitter based on a nonlinear process driven by a cheap, low-power continuous-wave infrared laser diode. The nonlinear medium is a specially designed amorphous material composed of symmetry-free, diamondoid-like cluster molecules that are readily obtained from ubiquitous resources. The visible part of the spectrum resembles the color of a tungsten-halogen lamp at 2900 kelvin while retaining the superior beam divergence of the driving laser. This approach of functionalizing energy-efficient state-of-the-art semiconductor lasers enables a technology complementary to light-emitting diodes for replacing incandescent white-light emitters in high-brilliance applications.

The invention concerns a highly efficient directional molecular white-light emitter driven by a continuous-wave laser diode. The invention describes amorphous materials that emit a broadband (warm white) spectrum of light upon excitation with an infrared laser via highly nonlinear processes. Inorganic nanocrystals form the core of their material and are coated with organic ligands on the surface. When excited with infrared light, nonlinear optical processes cause the material to emit broadband white light. The new light source is both efficient and environmentally benign.

Here, a molecule-based solid compound is used by the inventors as an extremely nonlinear medium. It enables the steady-state operation of a low-etendue, directional broadband white-light source covering the entire visible spectrum driven by a low-cost infrared laser diode. The compound comprises semiconductor-based cluster molecules decorated with covalently attached organic ligands supplying quasidelocalized electrons. The overall goal was to synthesize an amorphous compound combining a suitable band-gap inorganic semiconductor cluster core with organic ligands providing delocalized electrons in the electronic ground state of the molecule, while being composed of components that are ubiquitous, thus readily obtainable and cheap.

The basic experiments were conducted by use of derivates of tetrel-chalkogenides like $SnS_2$, $GeS_2$ etc. forming the semiconductor-based core-structure of the cluster molecules, like $(R^{deloc}Sn)_4S_6$. It is obvious to the person skilled in the art, that other binary semiconductors which are providing a large transition dipole moment can also form a semiconductor-based core-structure. Thus it is obvious that the invention also comprises compounds comprising the Elements B, Al, Ga, In, Tl and N, P, As, Sb, Bi in binary combinations of any group 13-Element with any group 15-Element.

The inventors produced tin-sulfide-based molecules with an adamantane-like, thus diamondoid, $[Sn_4S_6]$ scaffold. The latter is free of inversion symmetry because it has a tetrahedral shape. Lower molecular symmetry and delocalization of electronic states are realized by decoration of the core with randomly oriented organic ligands (substituents) $R^{deloc}$= 4-$(CH_2{=}CH)$-$C_6H_4$ (Fig. 1A). The steric influence of the organic ligands defines the molecular structure of the cluster core and the noncrystalline nature of the compound. It prevents polymerization of the inorganic cluster moieties into the binary $SnS_2$ solid; the vinyl groups in para position of the tin atoms are also available for further chemical modification. Additionally, they enable covalent attachment of the clusters to inorganic materials. It is well known to the person skilled in the art, that other substituents, e.g. hydroxyl groups, thiol groups etc., can also be used for these purposes, so that the usage of such groups for chemical modification and/or covalent attachment to surfaces also lies within the scope of the invention.

It is also well known to the person skilled in the art that the lower molecular symmetry and delocalization of electronic states of compounds of type $[(RT)_4E_6]$ (E = O, S, Se, Te; T = Sn, Si, Ge, Pb) can also be realized by use of the ligands contained in the list comprising phenyl, benzyl, styryl; aromatic polycyclic substituents/ligands, for example naphthyl, anthryl, phenanthryl; heteroaromatic monocyclic substituents/ligands, for example pyridyl; heteroaromatic polycyclic substituents/ligands, for example aza-naphthyl, aza-anthryl, aza-phenanthryl, diaza-naphthyl, diaza-anthryl, diaza-phenanthryl, bipyridyl, terphenyl. The inorganic scaffold is kinetically protected by the sterical influence of the organic substituents. Even small substituents like methyl groups effectively prohibit decomposition of the cluster structure under formation of the thermodynamically favored inorganic sulfides, e.g. tinsulfide.

The compound $[(R^{deloc}Sn)_4S_6]$ was obtained as a fine amorphous powder (Fig. 1B). Its identity was confirmed by mass spectrometry (Fig. 5). The compound is nonvolatile, air-stable, and thermally stable up to 573 K (Fig. 6). Its molecular structure was rationalized by quantum chemical calculations employing density-functional-theory (DFT) methods (Fig. 7). The compound retains its chemical and physical characteristics when embedded inside an acrylamide-based matrix. The emission for 800-nm continuous-wave (CW) laser excitation gives a warm-white color impression (Fig. 1C). It is very close to a standard tungsten-halogen light source at 2856 K for the maximum pump fluency and changes with variation of the excitation density (Fig. 1D).

Although the color impression closely resembles an incandescent source, the characteristic directional features of the driving CW laser are retained by the nonlinear medium. The angular emission pattern for excitation with a loosely focused CW near-infrared laser beam (Fig. 2A) shows that the white-light emission features a very narrow angular spread. Its emission cone is broader than that of the driving laser, as expected for scattering due to the amorphous character of the compound (Fig. 10). This implies that the approach of the inventors should enable the realization of high-brilliance sources for targeted, directional illumination and projection applications. Here, one should hence be able to outperform conventional approaches with respect to directionality: Thermal emitters are inherently omnidirectional, and LEDs typically exhibit Lambertian emission.

The emission spectra corresponding to the color temperatures in Fig. 1D are given in Fig. 2B. The dispersed emission covers the entire visible spectrum; its spectral weight is shifted toward lower energies compared with characteristic white-light LED emission. The spectral distribution of the white light is virtually independent of the excitation wavelength in the range from 725 to 1050 nm (Fig. 8). This property is highly desirable for integration into laser-diode devices because it implies robustness to thermal- or manufacturing-related variations in the driving-laser wavelength. The nonlinear behavior is visualized in the input-output characteristic given in Fig. 2C. The white-light output power as a function of pump-power density reveals an extreme nonlinearity, which scales approximately to the eighth power. Currently, the optimum supercontinuum generation efficiency close to the destruction threshold is determined to be in the range of 10%. Even at this early stage and imperfect sample quality, this efficiency is comparable to widely used phosphors. The samples have shown notable long-term stability under operation conditions for several months.

To gain insight into the underlying mechanism of white-light generation, the inventors compare the spontaneous emission for above-bandgap UV excitation to the white-light characteristics (Fig. 3A). The spontaneous emission is a mirror image of the linear absorption, as expected from the Franck-Condon principle. The white-light spectrum is shifted

to lower energies; only the high-energy cutoff appears to be limited by reabsorption in the dense amorphous molecular solid. Furthermore, it should be noted that the spontaneous emission is several orders of magnitude less bright than the white light. The photon energy of the driving laser is detuned very far off resonance, and no indications of emission after multiphoton excitation are seen. Further differences are observed for the lifetimes for pulsed excitation of the spontaneous emission and the white light (Fig. 3B). The spontaneous emission decays on a 100-ps time scale, whereas the white light intriguingly shows virtually no time dynamics at all, inferring an instrument-limited lifetime of more than 10 ms. The long lifetime excludes conventional coherent processes as the source of the broad spectrum, and it implies that for CW irradiation, the directionality is caused by a phased-array effect induced by the continuously present electric field of the driving laser.

All of the above considerations imply a mechanism for white-light generation (Fig. 3C), whereby the near-infrared laser drives the virtually delocalized electrons supplied by the $\pi$-electron systems of the organic ligands. For CW irradiation, the charges are driven in the electronic ground-state potential of the molecule and dominantly relax via radiative loss in energy, commonly termed bremsstrahlung. These features are captured qualitatively in a model of the emission resembling the classical motion of an electron invoked by an external driving field. The ground-state potential landscape is approximated by an anharmonic oscillator with a third-order perturbation. This simplification is justified by the small energy scale below 3.5 eV considered here, compared with the ground-state ionization threshold calculated to 13.46 eV. Simulating the movement of an electron in said potential reveals the emission. Results from the calculation are plotted in Fig. 3D. The calculation yields the dominant emission peak around 2 eV in the visible, excellently reproducing the experimental data. The near-infrared emission peak predicted by the calculations is also observed experimentally, corroborating the applicability of this phenomenological model.

The reemission during the accelerated motion in the anharmonic molecular potential is conceptually similar to high-harmonic generation in noble gases or optically driven gas plasmas and the resulting plateau formation. The most remarkable difference, however, is the involvement of electrons in the electronic ground state only. This infers the low electric field strength required to invoke the broadband emission accessible even for CW lasers. Hence, the nonlinearity should depend critically on the electrons available in conjugated $\pi$-systems of the ligands and on the composition of the cluster core that provides the high-energy cutoff (Fig. 3A). This explanation is supported by systematic investigations with exchanged core and ligand structures. Replacing Sn with Ge increases both the ground-state potential depth and the fundamental electronic transition energies. Consequently, the supercontinuum's spectral bandwidth is increased toward higher energies. The importance of amorphousness becomes evident when replacing Sn with Si; a crystalline material is obtained and the supercontinuum is quenched.

The clusters are potentially integrated into a monolithic device. During vacuumdeposition, the clusters form thin amorphous layers on hydrogen-terminated silicon single crystals and on GaAs, the latter being particularly important for integration into diode lasers. The high-angle annular dark-field scanning transmission electron microscopy (TEM) image for deposition on a GaAs (001) surface is given in Fig. 4A [Fig. 12 for the deposition on Si (001)]. The width of the amorphous molecular layer observed in the high-resolution micrograph (Fig. 4B) is in excellent agreement with a cluster molecule's dimensions; this suggests that the surface is coated by a self-limited monolayer. The composition across the interface (Fig. 4C) and the energy-dispersive x-ray (EDX) (Fig. 4A) corroborate these findings. The approach of the inventors provides a route for a directional white-light device for low-etendue applications complementary to conventional nonlinear sources or solid-state emitters such as LEDs by the functionalization of a low-cost infrared diode laser. Additionally, it was surprisingly found by the inventors that the transformation of infrared light into white-light is also working with simple light emitting diodes (LED), in which case the white-light is emitted non-directionally. Therefore the invention also comprises not just diode-lasers but also all other types of solid-state emitters emitting electromagnetic radiation with wavelengths beyond 750 nm, as well as their usage for generating white-light.

Within the following paragraphs, the fine-tuneability of the nonlinear response, i.e., changing from white-light generation to second harmonic generation as well as controlling the white-light properties is demonstrated. These are investigated as a function of T, $\pi$-delocalization of the electron density within R, and the order within the molecular solids.

For this purpose, two series of compounds of the general formula $[(RT)_4S_6]$ (R = organic ligand; T = Si, Ge, Sn) are prepared. All of these compounds are expected to exhibit (very) strong nonlinear optical properties, as they have similar compositions and structures as the proof-of-principle compound **1.**

One series addresses the effect of the ligands on the $[(RSn)_4S_6]$ scaffold. The ligands are varied from R = methyl (Me, **2**) through R = 1-naphthyl (Np, **3**) and styryl (Sty, **1**) to R = phenyl (Ph, **4**) for exploration of the impact of the presence and the nature of the $\pi$-electron system. For this, it is either completely absent (Me) or decreases in size (Np $\rightarrow$ Sty $\rightarrow$ Ph). Changing the ligand particularly changes the intermolecular interactions, including the tendency of the solid material to exhibit no, short-range, or long-range order, which determines its amorphousness versus crystallinity. A second series addresses the composition of the inorganic cluster core. This affects the optical gap of the clusters, starting out from the Sn/S combination in **4** through Ge/S (**5**) to Si/S (**6**). Overall, the two sample series reveal (i) whether and how the T/E/R combination affects the orderliness or potential crystallization and (ii) how this affects the nonlinear optical properties.

Except for compound **6,** the compounds are obtained as amorphous powders under a large variety of reaction and crystallization conditions tested to date. Hence, the molecular structures of the latter are elucidated via density functional theory (DFT) calculations (see section embodiments of the invention). According to these, all of the compounds are based on a heteroadamantane-type [$T_4S_6$] scaffold, which is energetically favored over the "double-decker"-type isomer by 19.2-36.4 kJ/mol (see Fig. 19, section embodiments of the invention). The organic substituents point away from the center of the inorganic cluster core in pseudo-tetrahedral fashion. As an exception, compound **6** could be obtained as single crystals. Thus, the structure of this compound was determined by single-crystal X-ray diffraction. The structure is solved and refined in the monoclinic space group $P2_1/c$ with Z = 4 (see Fig. 24 and section embodiments of the invention). In agreement with DFT calculations, the molecular structure of **6** is based on an inversion-free heteroadamantane-type inorganic scaffold with (idealized) $T_d$ symmetry. The actual crystallographic symmetry is reduced by different orientations of the organic groups and by slight deformations of the inorganic core.

Next, the nonlinear optical properties of the compounds is investigated. The samples are kept under high-vacuum conditions during laser irradiation. For excitation, a continuous-wave diode laser operating at a central wavelength of 980 nm is used. The optical power of 200 mW is focused on the sample in a confocal setup featuring a reflective microscope objective to avoid any chromatic aberrations (see section embodiments of the invention). This setup yields a spot diameter of less than 10 $\mu$m on the sample. For detection, a Czerny-Turner-type spectrometer equipped with a thermoelectrically cooled back-illuminated deep-depletion Si-charge-coupled device camera is used. Residual scattered pump laser is attenuated using a heat-absorbing glass filter (Schott KG3).

Characteristic spectra of the first sample series (compounds **1-4**) are given in Fig. 25. Clearly, the nature and extent of the $\pi$-electron system crucially influence the optical nonlinearity. Compounds **1** and **4** show pronounced white-light emission, while compounds **2** and **3** show intense SHG. The latter requires phase matching (which is not a precondition for white-light emission). Hence, the optical experiments infer a certain degree of order in the powders obtained for **2** and **3.** In **2,** both the low steric demand and the low flexibility of the ligand seem to allow for order - which can even lead to the formation of single crystals - although it is not visible in the X-ray diffraction diagrams of the powder studied herein (Fig. 18). In the case of **3,** the pronounced $\pi$-$\pi$-stacking capability of the Np ligands apparently causes a relatively high degree of order in the amorphous powder. Hence, the two ligands, although significantly different in size and electronic nature, provoke similar nonlinear responses.

The situation changes upon attachment of ligands with a medium-sized extension of the $\pi$-electron system. Obviously, an effective intermolecular interaction does not take place between the cluster molecules in **1** (R = Sty), which is attributed to both the reduced $\pi$-stacking capability compared with Np ligands and the higher conformational flexibility of the Sty ligands compared with all of the other ligands involved herein. The smallest $\pi$-electron system in this series is present in the Ph groups in compound **4.** Like the Sty ligands in **1,** they hamper any intermolecular order when attached to the [$Sn_4S_6$] core. Hence, phase matching is ruled out, and the nonlinear optical response changes from SHG to white-light generation.

The subtle yet crucial role of microscopic molecular order is further underlined by the slightly reduced white-light generation in **1** compared with **4.** In these compounds, the delocalization of the $\pi$-electron system is virtually identical. Nevertheless, the Sty ligands in **1** provide an increased potential for dispersive interactions between neighboring molecules and thus a potentially higher degree of order in the material, without reaching long-range order or crystallinity. Thus, the strength of the nonlinear optical response might in turn be used as a measure of the degree of intermolecular order in a macroscopically amorphous compound.

The strong nonlinear response found for all four compounds underlines the efficient enhancement of the nonlinearity by the transition dipole moment of the cluster core. Hence, even compound **2,** with its comparatively small electronic system, exhibits SHG, as the Me groups are in close proximity to the inorganic core.

The second group of samples comprises compounds **4, 5,** and **6.** Here the inorganic cluster core is varied while the Ph ligands, which proved as most suitable for white-light generation in the first series, remain unchanged. In striking difference to the other two Ph-decorated compounds, **6** is obtained as clear and sizable single crystals (Fig. 22). This difference in appearance is directly reflected in the measured spectra shown in Fig. 26. SHG is exclusively observed for the crystalline compound whereas the other two exhibit broadband white-light emission, in perfect agreement with the conclusions given above.

The fact that Ph ligands, which perfectly exclude crystallization in the case of compounds **4** and **5,** do allow for the longer-range order in a crystal lattice in **6,** can be attributed to the different relative sizes of the three components T, E, and R. Obviously, four Ph ligands match well the steric demands of the [$Si_4S_6$] scaffold to form a stable crystal structure with interdigitating Ph groups that, however, do not feature any typical $\pi$-stacking orientations with respect to each other. In contrast, a suitable crystal lattice is lacking in the T/E/R = Sn/S/Ph and Ge/S/Ph combinations in **4** and **5,** respectively.

Comparison of the spectra of **4** and **5** reveals a blue shift of the maximum and of the high-energy flank when Sn is replaced with Ge. The white-light spectrum in both compounds is limited by reabsorption from the fundamental electronic transition of the cluster core. In accordance with the band gaps of $SnS_2$ and $GeS_2$ (2.18-2.44 eV and 3.2 eV,

respectively), the reabsorption limit in compound **5** is blue shifted relative to that in **4.** This is confirmed by UV/Vis absorption spectroscopy (Fig. 17). The white-light spectrum in both compounds is limited by reabsorption from the fundamental electronic transition of the cluster core.

Thus the invention can be characterized as follows:

The invention comprises at least one non-crystalline resp. amorphous Compound/Material, characterized in that the Compound/Material comprises a diamandoid core-structure containing at least one atom of at least one chemical element, chosen from the list comprising Si, Ge, Sn, Pb, O, S, Se, Te whereby the atoms forming the diamandoid core-structure are chosen independently from each other and may or may not carry substituents/ligands.

The core-structure of the compound may be formed by inorganic nanocrystals of the above mentioned material comprising at least one chemical element, chosen from the list comprising Si, Ge, Sn, Pb, O, S, Se, Te. In this case the nanocrystals are coated with organic ligands on the surface.

The invention further comprises at least one Compound/Material as previously described, characterized in that the substituents/ligands are independently from each other chosen from the list comprising Phenyl, Benzyl, Styryl; aromatic polycyclic substituents/ligands, for example Naphthyl, Anthryl, Phenanthryl; heteroaromatic monocyclic substituents/ligands, for example Pyridyl; heteroaromatic polycyclic substituents/ligands, for example aza-Naphthyl, aza-Anthryl, aza-Phenanthryl, diaza-Naphthyl, diaza-Anthryl, diaza-Phenanthryl.

An especially preferred compound according to the invention exhibits a molecular structure according to Formula I:

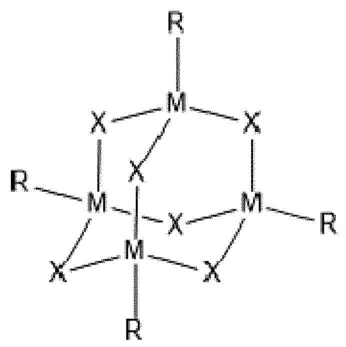

**(I)**

In Formular (**I**)

- atoms M are chosen independently from each other from the list comprising Si, Ge, Sn, Pb and
- atoms X are independently from each other chosen from the list comprising O, S, Se, Te and
- the substituents (organic ligands) R are independently from each other chosen from the list comprising Phenyl, Benzyl, Styryl; aromatic polycyclic substituents, for example Naphthyl, Anthryl, Phenanthryl; heteroaromatic monocyclic substituents, for example Pyridyl; heteroaromatic polycyclic substituents, for example aza-Naphthyl, aza-Anthryl, aza-Phenanthryl, diaza-Naphthyl, diaza-Anthryl, diaza-Phenanthryl.

The invention further comprises a compound as previously revealed, where the substituents are randomly oriented organic ligands.

The invention further comprises the usage of the compound(s) as previously revealed within an electronic device.

The invention further comprises the usage as previously revealed, characterized in that the electronic device is directionally emitting white light.

The invention further comprises the usage as previously revealed, characterized in that the electronic device is chosen from the list comprising laser-diodes, semiconducting laser-diodes, waveguides, light emitting diodes (LED), organic light emitting diodes (OLED), light emitting transistors, LED-screens, OLED-screens, backlight-devices of TFT-displays.

The invention further comprises the usage as previously revealed, characterized in that the compound is integrated into a monolithic device.

The invention further comprises the usage as previously revealed, characterized in that the compound is applied via vacuum deposition on hydrogen-terminated silicon single crystals and/or on GaAs, whereat the compound forms amorphous layers.

The invention further comprises the usage as previously revealed, characterized in that at least one type of substituent, attached to the diamandoid core-structure is used for further chemical modification and/or covalent attachment of the compound to inorganic materials.

The invention further comprises a polymer film comprising at least one inventive Compound as previously

described. The invention also comprises a device comprising the polymer film whereat the polymer film is located distant from an infrared laser diode emitting laser light with a wavelength between 800 nm and 1100 nm. In another embodiment the polymer film is located between two glass slips or other types of coverings from which at least the one which is located more closely to the infrared laser diode is transparent for laser light.

The invention is also comprising a layer comprising at least one inventive Compound as previously described.

**Detailed embodiments of the invention**

Synthesis and characterization methods

All manipulations were performed under argon atmosphere. Acetone was dried and freshly distilled prior to use, as well as all other solvents. Distilled water was degassed freshly prior to use. Trichloro(4-vinylphenyl)tin ($R^{deloc}SnCl_3$, $R^{deloc}$ = 4-($CH_2$=CH)-$C_6H_4$) (**A**) was prepared according to the method reported in the state of the art. [$(MeSn)_4S_6$] (**2**), [$(NpSn)_4S_6$] (**3**, Np = 1-naphthyl), [$(StySn)_4S_6$] (**1**, Sty = para-styryl), and [$(PhSn)_4S_6$] (**4**) are also prepared according to methods reported in the state of the art. $Na_2S\cdot 9H_2O$ and all other reagents are purchased from Sigma-Aldrich.

Melting points were measured in a sealed glass tube on a Krüss KSP1N melting-point apparatus. Nuclear magnetic resonance ($^1$H NMR, $^{13}$C NMR, $^{29}$Si and $^{119}$Sn NMR) measurements were carried out using a Bruker DRX 300 MHz and DRX 500 MHz spectrometer at 298 K. The chemical shifts were quoted in ppm relative to the residual protons of deuterated solvent in $^1$H NMR and $^{13}$C NMR. $Me_4Sn$ was used as external standard for $^{119}$Sn and $^{29}$Si NMR measurements. Infrared (IR) spectra were recorded on a Bruker Tensor 37. ESI-MS measurements were performed on a Thermo Fischer Scientifics LTQ-FT Ultra mass spectrometer. Energy-dispersive X-ray spectroscopy analysis, EDX, was performed using the EDX device Voyager 4.0 of Noran Instruments coupled with the electron microscope CamScan CS 4DV. Data acquisition was performed with an acceleration voltage of 20 kV and 100 s accumulation time. Elemental analysis was performed on an Elementarvario micro apparatus. μRFA is done employing a Bruker Tornado M4.

Synthesis and characterization of 1,3,5,7-Tetrakis(4-vinylphenyl)-2,4,6,8,9,10-hexathia-1,3,5,7-tetrastanna-adamantane, [$(R^{deloc}Sn)_4S_6$] **1**

$Na_2S\cdot 9H_2O$ (0.55 g, 2.3 mmol) was dissolved in a mixture of 5 mL water and 5 mL acetone. A solution of trichloro(4-vinylphenyl)tin (**A**; $R^{deloc}SnCl_3$, $R^{deloc}$=4-($CH_2$=CH)-$C_6H_4$), 0.50 g, 1.5mmol) in 3 mL of acetone was added dropwise at a temperature of 268 K. It was stirred at this temperature for 15 minutes. The resulting colorless precipitate was filtered, washed with water, and dried in high vacuum to become a fine homogeneous powder.

Yield: 0.36 g (0.33 mmol, 88 %); m.p.: not observed (slow decomposition above 573 K); $^1$H-NMR (300 MHz, DMF-$d_7$): δ 7.80-8.22 p.p.m. (m, 8H), 7.46-7.69 (m, 8H, Ph), 6.79 (dd, J = 10.9, 17.8 Hz, 4H, CH), 5.92 (d, J = 17.8 Hz, 4H, $CH_2$), 5.30 (d, J =10.9 Hz, 4H, $CH_2$); $^{13}$C-NMR (75 MHz, DMF-$d_7$): δ 114.94, 126.36, 135.03, 135.32, 136.92, 138.94; $^{119}$Sn-NMR (187 MHz, DMF-$d_7$): δ -258; IR: 2849 (w), 1626 (w), 1586 (w), 1547 (w), 1490 (w), 1386 (m), 1295 (w), 1185 (w), 1068 (w), 1024 (w), 1011 (w), 986 (m), 911 (m), 824 (s), 728 (w), 632 (w), 585 (m), 449 (s) $cm^{-1}$; HRMS (m/z; see Fig. 5: $[M+Na]^+$ calculated for $C_{32}H_{28}S_6Sn_4Na$, 1102.6497; found, 1102.6488; analysis (% calculated, % found for $C_{32}H_{28}S_6Sn_4$): C (35.60, 35.54), H (2.61, 2.23), S (17.81,17.34); EDX (calculated, found for $S_6Sn_4$): S (1.00, 1.00), Sn (0.67, 0.65).

As the compound is intrinsically amorphous, the suggested molecular geometry was calculated and validated by means of DFT calculations (see below).

Synthesis of 1,3,5,7-tetraphenyl-2,4,6,8,9,10-hexathia-1,3,5,7-tetrasilana-adamantane, [$(PhSi)_4S_6$]

Anhydrous sodium sulfide, $Na_2S$, (0.906 g, 11.6 mmol) was suspended in tetrahydrofurane (18 mL). At a temperature of 0°C phenyltrichlorosilane, $PhSiCl_3$, (1.61 g, 7.75 mmol) was added dropwise under stirring. After two hours the reaction was continued at room temperature for 22 hours. The solvent was evaporated and the residue was extracted with toluene (18 mL). The solvent was slowly evaporated and the product was isolated as single crystalline material.

Yield: 0.38 g (0.62 mmol, 33% single crystalline yield based on $PhSiCl_3$). $^1$H NMR (300 MHz, $CDCl_3$, 25 °C): 7.49 - 7.93 (m, 20H) ppm. $^{13}$C NMR (75 MHz, $CDCl_3$, 25 °C): 129.1, 132.6, 133.1, 135.2 ppm. $^{29}$Si NMR (99 MHz, $CDCl_3$, 25 °C): 8.5 ppm. IR: 442(w), 454 (w), 473(s), 492(m), 508(m), 555(s), 619(m), 688(s), 703(s), 738(s), 794(s), 863(m), 915(w), 925(w), 998(s), 1014(s), 1087(s), 1106(s), 1184(w), 1258(s), 1302(s), 1334(s), 1426(m), 1484(s), 1587(s), 2962(m), 3043(w), 3066(w) $cm^{-1}$. Analysis (% calcd, % found for $C_{24}H_{20}S_6Si_4$): C (36.43, 35.91), H (2.55, 2.52). μRFA (calcd, found for $S_6Si_4$): S (1.00, 1.00), Si (0.67, 0.66).

Synthesis of 1,3,5,7-tetraphenyl-2,4,6,8,9,10-hexathia-1,3,5,7-tetragermanaadamantane. [$(PhGe)_4S_6$]

Phenyltrichlorogermane, $PhGeCl_3$, (1.52 g, 5.93 mmol) was added at room temperature to a solution of sodium sulfide nonahydrate, $Na_2S \cdot 9H$ 2 O, (2.12 g, 8.90 mmol) in a solvent-mixture of water (10 mL) and acetone (8 mL). The resulting white precipitate was filtered and washed with water.

Yield: 0.63 g (0.80 mmol, 42% based on $PhGeCl_3$). $^1H$ NMR (300 MHz, DMF-$d_7$, 25 °C): 7.41-8.04 (m, 20H) ppm. $^{13}C$ NMR (75 MHz, DMF-d7, 25 °C): 130.4, 131.7, 133.0, 133.9 ppm. IR: 420(m), 457(m), 537(m), 617(w), 690(s), 732(s), 815(s), 834(m); 883(w), 929(m), 996(w), 1024(w), 1087(w), 1099(w), 1159(w), 1184(w), 1260(w), 1305(w), 1332(w), 1432(m), 1438(w), 3050(w), 3070(w) $cm^{-1}$. Analysis (% calcd, % found for $C_{24}H_{20}Ge_4S_6$): C (36.43, 36.40), H (2.55, 2.64). μRFA (calcd, found for $Ge_4S_6$): Ge (0.67, 0.64), S (1.00, 1.00).

Synthesis of 1,3,5,7-tetraphenyl-2,4,6,8,9,10-hexathia-1,3,5,7-tetragermanaadamantane. [$(PhGe)_4S_6$] (**5**)

Phenyltrichlorogermane, $PhGeCl_3$, (1.52 g, 5.93 mmol) is added at room temperature to a solution of sodium sulfide nonahydrate, $Na_2S \cdot 9H_2O$, (2.12 g, 8.90 mmol) in a solvent-mixture of water (10 mL) and acetone (8 mL). The resulting white precipitate is filtered and washed with water.

Yield: 0.63 g (0.80 mmol, 42% based on $PhGeCl_3$). $^1H$ NMR (300 MHz, DMF-$d_7$, 25 °C): 7.41-8.04 (m, 20H) ppm. $^{13}C$ NMR (75 MHz, DMF-$d_7$, 25 °C): 130.4, 131.7, 133.0, 133.9 ppm. IR: 420(m), 457(m), 537(m), 617(w), 690(s), 732(s), 815(s), 834(m); 883(w), 929(m), 996(w), 1024(w), 1087(w), 1099(w), 1159(w), 1184(w), 1260(w), 1305(w), 1332(w), 1432(m), 1438(w), 3050(w), 3070(w) $cm^{-1}$. Analysis (% calcd, % found for $C_{24}H_{20}Ge_4S_6$): C (36.43, 36.40), H (2.55, 2.64). μRFA (calcd, found for $Ge_4S_6$): Ge (0.67, 0.64), S (1.00, 1.00).

Synthesis of 1,3,5,7-tetraphenyl-2,4,6,8,9,10-hexathia-1,3,5,7-tetrasilanaadamantane, [(PhSi)4S6] (**6**)

Anhydrous sodium sulfide, $Na_2S$, (0.906 g, 11.6 mmol) is suspended in tetrahydrofurane (18 mL). At a temperature of 0°C phenyltrichlorosilane, $PhSiCl_3$, (1.61 g, 7.75 mmol) is added dropwise under stirring. After two hours the reaction is continued at room temperature for 22 hours. The solvent is evaporated and the residue was extracted with toluene (18 mL). The solvent is slowly evaporated and the product is isolated as single crystalline material.

Yield: 0.38 g (0.62 mmol, 33% single crystalline yield based on $PhSiCl_3$). $^1H$ NMR (300 MHz, $CDCl_3$, 25 °C): 7.49-7.93 (m, 20H) ppm. $^{13}C$ NMR (75 MHz, $CDCl_3$, 25 °C): 129.1, 132.6, 133.1, 135.2 ppm. $^{29}Si$ NMR (99 MHz, $CDCl_3$, 25 °C): 8.5 ppm. IR: 442(w), 454 (w), 473(s), 492(m), 508(m), 555(s), 619(m), 688(s), 703(s), 738(s), 794(s), 863(m), 915(w), 925(w), 998(s), 1014(s), 1087(s), 1106(s), 1184(w), 1258(s), 1302(s), 1334(s), 1426(m), 1484(s), 1587(s), 2962(m), 3043(w), 3066(w) $cm^{-1}$. Analysis (% calcd, % found for $C_{24}H_{20}S_6Si_4$): C (36.43, 35.91), H (2.55, 2.52). μRFA (calcd, found for $S_6Si_4$): S (1.00, 1.00), Si (0.67, 0.66).

Thermogravimetric analysis (TGA) and differential scanning calorimetry (DSC)

The TGA/DSC measurements were performed simultaneously on a Netzsch STA 400 with a heating rate of 10 K/min in Ar atmosphere in an $Al_2O_3$ crucible. The compound decomposes slowly above 573 K in an endothermic process (see Fig. 6). The decomposition is also observable optically by the generation of a grey powder. The maximal mass loss is observed at about 603 K. The mass loss is presumably dominated by the abstraction of organic fragments. At 643 K the speed of abstraction of the organic periphery decreases and continues as a slow process.

The thermal decomposition of the compounds in inert Ar atmosphere is observed at about 220 °C (**2**), 270 °C (**3**), 285 °C (**1**), 250 °C (**4**), 310 °C (**5**) and 370 °C (**6**), as shown in Fig. 16. In all these cases, the decomposition is an endothermic process.

Methods of Quantum chemical investigations

For density functional theory (DFT) calculations the program system TURBOMOLE Version 7.0, using the RIDFT program with the BP86 functional and grid size m3 was used. Basis sets were of def2-TZVP quality. For Sn atoms effective core potentials (ECP-28) have been used. No symmetry restrictions (i.e., C1 symmetry) during simultaneous optimizations of geometry and electronic structure were hold. The accuracy of the structures was found within the typical error of the method. Electronic excitations were calculated within the program system by using the ESCF program.

Quantum-chemical investigations of structural isomers

According to the obtained sum formula of $(R^{deloc}Sn)_4S_6$, two isomers for the organotin sulfide cluster exist.

One isomer exhibits a hetero adamantane type scaffold with pseudo $T_d$ symmetry, the other isomer exhibits a double-decker like scaffold with pseudo $D_2$ symmetry (see Fig. 7). DFT calculations show that the hetero adamantine topology is energetically favored by about 28 kJ/mol (see Table 1, Fig. 13). For this reason the inventors presume that only the hetero adamantane type scaffold is present at room temperature. This is in agreement to reported phenyl substituted organotin sulfide clusters $(R'Sn)_4S_6$ (R' = $C_6F_5$, 2,4,6-(CH3)3C6H2, 4-$(CH_3)C_6H_4$). The rotation of one organic ligand by 180° in the axis of the corresponding C-Sn bond has a minor influence to the total energy of less than 0.1 kJ/mol. Structural data are provided in Table 2, Fig. 14.

Calculation of the lowest triplet and singlet excitations, gained from time-dependent DFT (TD-DFT) calculations of the most stable isomer, are in perfect agreement to the observed optical absorption behavior. The lowest singlet excitation exhibits 3.15 eV. The lowest triplet excitation exhibits 2.80 eV, being shifted by 0.3 eV towards lower energy due to fact that electron exchange energy is gained in these case. For higher triplet excitations the energies converge beyond 12 eV which is in good agreement with the 13.46 eV ionization energy used in the simulation of the anharmonic potential.

Linear optical absorption spectroscopy

The linear optical absorption behavior was examined by means of UV-visible spectroscopy, measured as powder in reflectance mode under ambient conditions on a Varian Cary5000 spectrometer. Sample spectra are shown in Fig. 17.

X-Ray Powder Diffraction

In order to confirm the amorphous nature of compounds 1 to 5 as well as the crystallinity of compound **6,** all samples are examined by means of X-ray powder diffraction. The diffractograms are shown in Fig. 18. Powder X-ray diffraction patterns are measured on a StadiMP diffractometer by Stoe equipped with a Mythen 1K silicon strip detector and a Cu-K$\alpha$ ($\lambda$ = 1.54056 Å) x-ray source. Samples are measured in transmission between two layers of Scotch Tape (3M).

Single Crystal X-Rav Crystallography of Compound **6**

Data of the X-ray diffraction analyses are collected on a diffractometer equipped with a STOE imaging plate detector system IPDS2 using $Mo_{K\alpha}$ radiation with graphite monochromatization ($\lambda$ = 0.71073 Å) at 100 K. Structure solution is performed by direct methods, full-matrix-least-squares refinement against $F^2$ using SHELXTL software. Table 4 (Fig. 19) summarizes data collection and refinement details.

Density Functional Theory (DFT) Calculations

Methods of the quantum chemical investigation of compounds **1 - 6:** For the DFT calculations, the program system TURBOMOLE Version 6.5 using the RIDFT program with the BP86 functional and grid size m3 is applied. Basis sets are of def2-TZVP quality. For Ge and Sn atoms, effective core potentials (ECP-28) is employed. The simultaneous optimization of geometric and electronic structures are done without symmetry restrictions ($C_1$ symmetry). The accuracy of the structures is found within the typical error of the method.

According to the obtained general sum formula of $[(RT)_4S_6]$ (T = Si, Ge, Sn) two isomers for the organotetrel sulfide cluster exist. One isomer exhibits a hetero adamantane type scaffold with pseudo $T_d$ symmetry, the other isomer exhibits a double-decker like scaffold with pseudo $D_2$ symmetry. DFT calculations show that the hetero adamantane topology is energetically favored in every case with various substituents (R = H, Me, Ph) by 20.7 to 41.0 kJ. For compounds **1 - 6,** the calculated values are given in Table 5 (Fig. 21). For compound **5** the hetero-adamantane scaffold is energetically favored by 19.2 kJ/mol. For this reason it can be presumed - without being confined to a certain theory - that only the hetero adamantane type scaffold is present at room temperature.

Angular-resolved spectroscopy

The angular-resolved spectroscopy was performed using a 980 nm, 200 mW continuous-wave laser module for excitation. The collimated laser was focused onto the sample using a 5 cm focal-length lens (see Fig. 8, part A). The sample was mounted inside a small vacuum chamber and kept in vacuum at room temperature (293 K). Residual transmitted laser light was blocked using a 3 mm Schott KG3 heat-protective filter-glass. The light emitted from the sample was then collected by a 200 $\mu$m diameter, 0.12 numerical aperture (NA) optical fiber. The fiber was mounted such, that the center of rotation coincides with the incident laser focus on the sample. Chromatic dispersion and detection

of the emitted light was done using a compact spectrometer (OceanOptics USB2000) which was carefully calibrated using a traceable tungsten-halogen standard source.

Time-resolved photoluminescence spectroscopy

Time-resolved photoluminescence spectroscopy (TRPL) was performed using a confocal microscopy setup using a streak camera for detection as depicted in Fig. 8, part A. For excitation, we used 100-fs pulses from a Ti:Sapphire laser oscillator with an repetition rate of 78 MHz. Extending its intrinsic operating range, the pulsed could be frequency doubled or tripled. The pulses are focused onto the sample using a 0.5 NA reflective microscope objective. The samples are kept in vacuum inside a cryostat. All measurements are performed at room temperature (293 K). The emission from the sample is collimated in reflection geometry using the same objective and is then imaged either onto a charge-couple device (CCD) camera or onto the entrance slit of a Czerny-Turner-type spectrometer. A spatial resolution <5 μm was achieved for optical control by the CCD-camera. Chromatic dispersion was performed using a 40 g/mm grating with a blaze angle of 500 nm. Time-resolution was provided by a standard synchronously scanning Hamamatsu streak-camera. This setup provides a time-resolution of 1.5 ps with an overall time-window of 1.5 ns.

Steady-state white-light spectroscopy

Steady-state white-light emission spectroscopy was performed using the same optical path and sample holder as for TRPL. A 980 nm, 200 mW laser diode module operating in continuous-wave mode was used for excitation instead of the Ti:sapphire laser. A thermoelectrically-cooled Si-CCD camera is used for detection in the VIS/NIR spectral range. For detection in the NIR/IR range a thermoelectrically cooled (Ga,In)As-CCD camera is used. The cameras are mounted to the second output port of the same imaging spectrometer used for the TRPL experiments. However, here a grating with 122 grooves/mm blazed at 500 nm is used.

Spectral response correction

All setups were corrected across an extended visible spectral range (300 - 1100 nm) for the spectral response characteristics to derive the CIE values from the measured spectra. Therefore, a standard traceable tungsten-halogen lamp with a fixed temperature of 2000 K is mounted at a position equivalent to the sample. The spectrum of the lamp was then recorded with both the TRPL and steady state luminescence setup, compared to the supplied black-body spectrum of 2000 K and the correction factor derived.

Influence of excitation wavelength

To check on the influence of the excitation wavelength multiple spectra of the white-light were obtained using the Ti:sapphire laser tuned to different wavelength, ranging from 725 to 1050 nm. For all these spectra the laser was operating in CW-mode, i.e., not mode-locked. The resulting spectra are given in Fig. 9, part A and do not show significant dependence on the excitation wavelength.

Influence of sample temperature

To exclude thermal emission as a source of the white-light multiple spectra at different sample temperatures were obtained using the steady-state setup with the 980 nm, 200 mW laser diode for excitation. The excitation density was held constant for all measurements. Here, the sample was cooled by liquid nitrogen in the flow cryostat in contrast to all other measurements. The resulting spectra are shown in Fig. 9, part B. No significant change in spectral line shape is observed ruling out a purely thermal process as the latter would yield changes in the spectral shape similar to those observed for different pump-densities.

Light microscopy

Bright field images of cluster powder layers used to generate supercontinuum were obtained using a standard microscope (Askania RMA5) in reflection geometry. The images were recorded using a Panasonic KR222 CCD-camera. For sample preparation, the powder was dispersed on a coverslip and then capped by another. On a longer-range scale of about 100 μm the powder layer is very inhomogeneous with empty spaces between fully covered areas (see Fig. 10, part A). On the fully covered areas, however, the grain size was determined to vary from < 1 μm up to about 5 μm (see Fig. 10, part B-D).

Microscopy photographs of the compounds **4, 5** and **6** are taken with a stereo microscope (Carl Zeiss -STEMI

SV 6) equipped with a standard CMOS camera. The compounds **4** and **5** are obtained as amorphous powders (cf. Fig. 22, a/b). Compound **6** produces large crystallites as shown in Fig. 22, c.

Measurements of the Nonlinear Optical Response

The nonlinear responses of the samples are measured using the setup depicted in Fig. 23. The powders are kept inside a small vacuum cell with BK7 windows at pressures below $10^{-3}$mbar. The continuous-wave 980 nm light from a laser diode is focused onto the samples using a 0.5 NA reflective microscope objective in a confocal geometry. A heat absorbing filter (Schott KG3) in the recollimated beam is used to block the residual pump laser. The remaining light, white-light or the second-harmonic, is then focused onto the entrance slit of a Czerny-Turnertype spectrometer where the dispersed spectrum is detected using a thermoelectrically cooled back-illuminated deep-depletion silicon charge-coupled device array sensor.

Conversion efficiencies

Both Mie and Rayleigh scattering are very efficient as the samples are very inhomogeneous and the grain size is in the (sub-)μm range (see light-microscopic investigations above and Fig. 10). This leads to large uncertainties in determining the conversion efficiency. Hence, determining the actual net pump intensity that is converted into the supercontinuum is particularly challenging. To assess the uncertainties and avoid any systematic errors the inventors determined the conversion efficiency in several independent ways through different measurements to give the best possible estimation of conversion efficiency. In all cases, a continuous wave Ti:sapphire laser tuned to 980 nm was used for excitation. The laser was focused using a 1" diameter lens and the sample was kept between two coverslips.

As first method, the efficiency was measured only in forward direction: a high-sensitivity thermal power meter (Thorlabs S401C) was placed behind the sample. Benefit of this method is that power density impinging on the detector is relatively high resulting in an accurate estimation of the emitted power. Different filters were placed in front of the detector in order to ensure that only the desired powers are measured, i.e., a 3 mm thick Schott color glass filter (RG850) discriminated the laser intensity and a 900 nm cut off hard-coated short pass filter with more than five orders of magnitude rejection was used to measure the white light emission. This yielded a power of 400 mW with only two coverslips without sample in the beam path. Upon insertion of sample in the beam path, this is reduced to 290 mW; however, it was initially mounted out of focus so that the excitation density is below the supercontinuum threshold and no white light emission occurs. This loss of transmitted laser power is due to the efficient scattering of the sample. Powers of 1.6 mW and 7.36 mW were measured for the white light and the residual laser, respectively, once the sample is placed in the focus and the supercontinuum threshold is overcome. This leads to an efficiency of around 0.5 %, but changing the excitation spot size by moving the sample into focus also changes the scattering and thus leads to an underestimation of the efficiency.

To account for the backscattering, the inventors used a 20 cm diameter integrating sphere. While this reduces the errors due to scattering, one can no longer separate the transmitted and scattered contributions and the power density on the detector will be lower resulting in a larger uncertainty of the measured power. This setup yields a laser power of 2.1 mW at the 5 mm diameter output port below supercontinuum threshold. Above threshold, the inventors find powers of 280 μW for the white light and 750 μW for the residual laser, yielding an efficiency of 20.74 ± 5.51 %.

To support these values, the inventors repeated the measurements using a calibrated Si-diodebased power meter. While this ensures higher accuracy of the power determination due to its larger sensitivity, a proper spectral response needs to be taken into account. The inventors hence used two band pass filters with transmission of 440 ± 10 nm or 632.8 ± 3 nm to measure the power of two different spectral regions. These values were set in proportion to the overall emitted powers by scaling them with the corresponding emitted spectrum. This way, supercontinuum efficiencies of 16.71 ± 10.96 % and 9.05 ± 6.02 % are found using the 440 nm filter and the 632 nm filter, respectively.

Thresholds

The onset of the supercontinuum generation and the destruction limit of the sample are determined in a setup similar to the steady-state white-light spectroscopy setup discussed above. Now, the spectrometer was replaced by a higher throughput system. This is necessary to ensure more than 4 orders of magnitude in detection sensitivity. The driving laser was focused to a spot size of 0.00138 $cm^2$. The onset of white light generation was observed for ~1 mW, whereas the sample degenerated above -70-80 mW. This yields a threshold value of 0.7 $W/cm^2$ for the onset of supercontinuum generation, and a destruction threshold of 50 $W/cm^2$.

Comparison to thermal black-body emitter

To further exclude thermal radiation as the white-light source the respective color-temperature for every spectrum obtained in the pump-density dependence series was calculated. Then the emitted powers for every color temperature were estimated by integrating the respective spectrum.

The setup used to measure the spectra does not yield absolute values of emitted power hence only the relative powers can be compared. The normalized powers plotted vs. color temperatures are shown in Fig. 11. For comparison the $T^4$ dependence according to Stefan-Boltzmann law that would be expected if the source of the white-light was thermal is also plotted.

Furthermore a thermal process can be excluded to be the source of white-light radiation by the fact that the compound decomposes above 573 K (see Fig. 6). Hence heating the sample up to the range of -2000 K as it would be required to emit the observed spectra would ultimately result in a destruction of the sample.

Preparation for Immobilization on semiconductor surfaces

A freshly prepared hydrogen-terminated Si (001) surface or an oxide-terminated GaAs (001) surface and 10 mg 1 were placed next to each other in a glass vessel under Ar atmosphere. The vessel was heated to 523 K for 15 minutes. Subsequently, the surface was washed with THF, dried in high vacuum and stored in argon atmosphere. For measurements electron transparent foils of the molecular layers on GaAs (001) and Si (001) substrates were prepared in [110] zone axis of the substrates by conventional mechanical polishing followed by 5 KeV argon ion milling from both sides with an angle of incidence of 4° in a Gatan precision ion polishing system. Final polishing was carried out at 1.7 keV to reduce the amount of amorphous material on the samples.

Electron microscopy deposited on a Si (001) surface

The high angle annular dark field (HAADF)-Scanning TEM (STEM) measurements were carried out in a double aberration corrected JEOL 2200 FS, operating at 200 kV. A beam convergence semi-angle of 24 mrad was used and the annular detector was set to collect electrons scattered in the range between 73 and 173 mrads. For EDX spectroscopy in the STEM a Bruker Quantax X-Flash detector was used. The clusters form a perfectly amorphous layer on an H-terminated Si substrate as can be seen from Fig. 12. This molecular layer is separated from the substrate by a region of darker contrast due to the low-Z carbon containing side groups. The inventors find excellent agreement between the contrast seen from the scanning TEM image and the molecular dimensions, suggesting self-limited growth. The arrangement of the clusters is further confirmed by EDX line scans.

White-light spectrum simulation

Without being confined to a certain theory, the principle idea behind the white-light generation mechanism is the reemission from an accelerated electron in an anharmonic molecular ground-state potential. For the simulation, the electron experiences the simplified anharmonic potential (U) of the form:

$$U(x) = \tfrac{1}{2}\, m\omega_0^2 \cdot x^2 + \tfrac{1}{3}\, ma \cdot x^3 \qquad \text{(S1)}$$

Here, x denotes the elongation of the electron from the potential minimum, m is the electron mass, $\omega_0$ the normal mode of the oscillator, and a the strength of nonlinearity. This potential results in a restoring force of the form:

$$F(x) = -m\omega_0^2 \cdot x - ma \cdot x^2 \qquad \text{(S2)}$$

To get a rough estimate of the nonlinearity, we apply Miller's rule, i.e., for elongations equal to the size (d) of the oscillator the linear and nonlinear contributions to the restoring force become comparable. Inserting the size in (S2) leads to the following expression for a:

$$m\omega_0^2 \cdot d = \mathrm{ma} \cdot d^2 \implies a = \frac{\omega_0^2}{d} \qquad \text{(S3)}$$

Using this substitution the inventors get the equation of motion of the electron:

$$\ddot{x} + 2\gamma\dot{x} + \omega_0^2 x + a x^2 = -\frac{e}{m} E(t) \qquad (S4)$$

Here, $\gamma$ is the restoring force of the oscillator that is comparable to damping caused by radiative loss and $E(t)$ is the driving external electric field. This differential equation is solved numerically using the *odeint* algorithm of the *SciPy* Phython library. Calculations are performed on a time scale up to 100 ps width a step size of 0.1 fs. The electric field was assumed to be sinusoidal with the frequency of the pump-laser used in the experiment, for the used field-strength as well as the other parameters see: Table 3, Fig. 15. After calculating the movement of the electron the inventors take the Fourier transform of this movement to obtain the frequency components that are comprised in the oscillation of the electron. As a first estimate, this frequency component directly converts to the emitted spectrum.

**Description of the drawings**

Fig. 1A: Adamantane-like cluster $[(R^{deloc}Sn)_4S_6]$ (1, $R^{deloc}$ = 4-($CH_2$=CH)-$C_6H_4$), with tin and sulfur atoms drawn as dark grey and light grey spheres, respectively; carbon (gray) and hydrogen (white) atoms are given as wires.

Fig. 1B: Photograph of the as-prepared powder ($[(R^{deloc}Sn)_4S_6]$ ($R^{deloc}$ = 4-($CH_2$=CH)-$C_6H_4$)).

Fig. 1C: Photograph of a polymer film containing the cluster sandwiched between two cover glass slips excited by 800-nm laser light in the bright center spot.

Fig. 1D: Color temperatures given for various excitation fluencies, as indicated by individual gray-scale data points. The characteristic ideal black-body emission for various temperatures is indicated by the solid line; the square indicates the color temperature of standard emitter at T = 2856 K.

Fig. 2A: Highly directional spatial emission pattern of the white-light spectrum (white) and the CW excitation laser at 980 nm (densely filled).The intensity distribution of a perfect Lambertian emitter (sparsely filled) is given for reference.

Fig. 2B: White-light spectra for a pump wavelength of 980 nm. The pump power is varied from 6 mW (light gray solid line) to 18 mW (black solid line).The normalized curves for black-body radiation (T = 5000 K, dashed line; T = 2856 K, spaced dots) and a GaN-based white-light LED (narrow dots) are shown for comparison.

Fig. 2C: Double-logarithmic plot of the white light input-output characteristics. With a guide to the eye proportional to the $4^{th}$ power of the pump density.

Fig. 3A: Normalized linear absorption spectrum (continuous line), spontaneous emission for UV excitation above the fundamental electronic transition energy (dashed line), and white-light emission spectrum (continuous line marked with squares) for the driving infrared laser on a semilogarithmic scale.

Fig. 3B: The spontaneous emission (continuous line) decays significantly faster than the white light (continuous line marked with squares).

Fig. 3C: Schematic illustration portraying the white-light emission due to the accelerated motion of an electron (indicated by continuous-lined trajectory) in the anharmonic electronic ground-state potential (solid curve, marked Eo).

Fig. 3D: Experimental (solid) and calculated (dotted) white-light emission spectra agree excellently; the scattered part of the driving laser (shaded area) is not included in the simulation.

Fig. 4A: EDX spectra revealing the contributions of Sn and S in the amorphous cluster layer and Ga and As in the crystalline substrate.

Fig. 4B: The self-assembled monolayer shows long-range homogeneity and lacks any observable structure, and hence is perfectly amorphous, as can be seen from the high-resolution micrograph; a scaled structure model

is overlaid on the micrograph to illustrate the size.

Fig. 4C: Overlaid at the right side of the micrograph: EDX line scans indicating the distribution of the constituents. The length scale for both (B) and (C) is defined by the right vertical axis.

Fig. 5: Molecular peak [1+Na]+ in the high resolution ESI(+) mass spectrum of $[(R^{deloc}Sn)_4S_6]$. (A) Spectrum measured on a fresh solution of single-crystals of 1 in dichloromethane. (B) Simulated spectrum. Both the maximum abundance and the isotope patterns unambiguously confirm the identity of the compound with the given formula.

Fig. 6: Thermogravimetric analysis (TG, left vertical axis, dashed line) and differential scanning calorimetry (DSC, right vertical axis, continued line) of $[(R^{deloc}Sn)_4S_6]$. The material is thermally stable up to ca. 573 K before an endothermic event is observed that is due to the release of organic ligands to form $SnS_2$.

Fig. 7: Minimum structures of $[(R^{deloc}Sn)_4S_6]$ derived from DFT calculations. (A) Cluster isomer based on a hetero-adamantane-type topology of the $[Sn_4S_6]$ scaffold. (B) Cluster isomer based on a so-called "double-decker"-like architecture of the $[Sn_4S_6]$ scaffold. The cluster based on the hetero-adamantane-type scaffold is energetically favored by about 28 kJ/mol over the other isomer (see Table 1, Fig. 13).

Fig. 8: (A) Setup for steady-state white-light spectroscopy and time-resolved photoluminescence spectroscopy. The setup for angular-resolved measurements is given in the inset.
(B) Emission characteristics for above band gap excitation. The incident laser (horizontally shaded area) induces the PL (black arrows) that is emitted omnidirectional.
(C) Emission characteristics for below band gap CW-irradiation. The incident laser (horizontally shaded area) induces the white-light emission (vertically shaded area) that is directional but flared around the transmitted laser. Residual emitted PL (dashed arrows) is orders of magnitude lower than for above band gap excitation.

Fig. 9: (A) White-light emission spectra for various excitation wavelengths indicated by the grey arrows (725-1050 nm). The curves are vertically offset and shifted horizontally for clarity.
(B) White-light emission spectra for various sample temperatures ranging from 70 K up to 325 K for CW-excitation at 980 nm.

Fig. 10: Reflected light microscopy bright-field images of powder $[(R^{deloc}Sn)_4S_6]$. (A-D) Images with increasing magnification: the cluster powder is dispersed on a coverslip and capped by another coverslip.

Fig. 11: Plot of the normalized emitted powers corresponding to the respective color temperature obtained for the different pump-densities. For comparison, the $T^4$ dependence according to Stefan-Boltzmann law expected for a thermal emitter is shown (shaded line).

Fig. 12: Compositional and structural characterization of functionalization characteristics on Si.

(A) EDX spectra.
(B) High-resolution micrograph of the clusters on Si-substrate, overlaid by a space-filling image of the cluster molecule.
(C) EDX line scans. The scatter of the S data is caused by the low signal to noise ratio of the S-related EXD signal.

Fig. 13: Table 1 - Total energies of the calculated $[(RSn)_4S_6]$ clusters. The $[Sn_4S_6]$ scaffold possesses either hetero-adamantane or double-decker type topology (see Fig. 7).

Fig. 14: Table 2 - Calculated structural parameters. The given data represent the structural parameters of the minimum geometry of $[(R^{deloc}Sn)_4S_6$ that is based on a hetero-adamantane type $[Sn_4S_6]$ topology.

Fig. 15: Table 3 - Parameters used to simulate the spectrum shown in Fig. 3.

Fig. 16: Thermogravimetric analysis (TGA) of compounds $[(PhT)_4S_6]$: **4** (T = Sn), **5** (T = Ge), and **6** (T = Si).

Fig. 17: Solid state UV/Vis spectra. Top: Spectra of compounds **2, 3** and **4.** Bottom: Spectra of compounds **4, 5** and **6.**

Fig. 18: Top: X-ray powder diffractograms of compounds **1, 2, 3, 4** and **5,** plotted one above the other in vertical direction for comparison. Bottom: X-ray powder diffractogram of compound **6** in comparison with a powder pattern simulated from the single crystal structure. The slight angular shift between measured and simulated diffractograms can be attributed to the single crystal measurement being carried out at 100 K while the powder diffractograms were measured at 293 K.

Fig. 19: Table 4 - X-ray data collection, structure solution and refinement data of **6.**

Fig. 20: Packing of the molecules in **6,** shown as 2x2x2 supercells with view along [100] (top), [010] (center), and [001] (bottom). H atoms are omitted for clarity, Si, S, and C atoms are located at the corners. Cluster scaffolds with their inorganic cores are drawn as lines, indicating relative positions of neighboring cluster molecules in the different directions. The relative orientations of the phenyl rings do not indicate $\pi$ stacking interactions.

Fig. 21: Table 5 - Subtraction of the total energies of the calculated heteroadamantane type clusters (AD) from the "double-decker" type clusters (DD). (Sty = para-styryl, Np = 1-naphthyl), indicating the energetic preference of the hetero-adamantane-type scaffold over the alternative one.

Fig. 22: Microscopy photographs of the compounds **4, 5** (a, b) and **6** (c).

Fig. 23: Setup for spectrally resolved measurements of the steady-state non-linear response.

Fig. 24: Fragment of (left) the crystal structure (wire representation, shown without H atoms) and (right) the molecular structure (ellipsoids drawn at the 70% probability level) of $[(PhSi)_4S_6]$ (**6**) according to X-ray diffraction studies. Selected structural parameters [Å, deg]: Si-S, 2.1184(5)-2.1476(5); C-Si, 1.854(1)-1.855(1); Si-S-Si, 102.86(2)-104.25(2); S-Si-S, 111.29(2)-113.27(2); C-Si-S, 103.85(5)-108.50(5).

Fig. 25: Emission spectra measured for an excitation wavelength of 980 nm. Compounds **2** and **3** exhibit intense SHG. Compounds **1** and **4** exhibit strong white-light emission (scaled by a factor of 3).

Fig. 26: Spectra measured for an excitation wavelength of 980 nm. The amorphous compounds **4** and **5** (dashed) exhibit strong white-light emission. The crystalline compound **6** exhibits strong SHG.

## Claims

**1.** A non-crystalline Compound, **characterized in that** the Compound comprises a diamandoid core-structure containing at least one atom of at least one chemical element, chosen from the list comprising Si, Ge, Sn, Pb, O, S, Se, Te, whereby the atoms forming the diamandoid core-structure are chosen independently from each other and may or may not carry substituents, the non-crystalline Compound exhibiting a molecular structure according to Formula **I**,

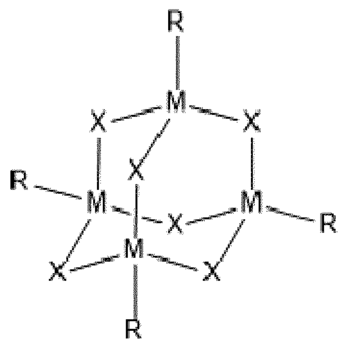

( I )

,

whereat

- the atoms M are independently from each other chosen from the list comprising Si, Ge, Sn, Pb and
- atoms X are independently from each other chosen from the list comprising O, S, Se, Te and

- the substituents R are independently from each other chosen from the list comprising Phenyl, Benzyl, Styryl; aromatic polycyclic substituents, for example Naphthyl, Anthryl, Phenanthryl; heteroaromatic monocyclic substituents, for example Pyridyl; heteroaromatic polycyclic substituents, for example aza-Naphthyl, aza-Anthryl, aza-Phenanthryl, diaza-Naphthyl, diaza-Anthryl, diaza-Phenanthryl,

whereat a compound comprising either Ge or Sn in combination with S does not comprise the substituent p-Styryl, whereat a compound comprising either Si or Sn in combination with S does not comprise the substituent Phenyl.

2. Compound according to claim 1, **characterized in that** the core-structure is formed by inorganic nanocrystals of the material comprising at least one chemical element, chosen from the list comprising Si, Ge, Sn, Pb, O, S, Se, Te, whereat the nanocrystals are coated with organic ligands on the surface.

3. Compound according to any one of the preceding claims, **characterized in that** the substituents are randomly oriented organic ligands.

4. Usage of a compound according to any one of the preceding claims within an electronic device.

5. Usage according to claim 4, **characterized in that** the electronic device is directionally emitting white light.

6. Usage according to claim 4 or claim 5, **characterized in that** the electronic device is chosen from the list comprising laser-diodes, semiconducting laser-diodes, waveguides, light emitting diodes (LED), organic light emitting diodes (OLED), light emitting transistors, LED-screens, OLED-screens, backlight-devices of TFT-displays.

7. Usage according to any one of the preceding claims 4 through 6, **characterized in that** the compound is integrated into a monolithic device.

8. Usage according to any one of the preceding claims 4 through 7, **characterized in that** the compound is applied via vacuumdeposition on hydrogen-terminated silicon single crystals and/or on GaAs, whereat the compound forms amorphous layers.

9. Usage according to any one of the preceding claims 4 through 8, **characterized in that** at least one type of substituent, attached to the diamandoid core-structure is used for further chemical modification and/or covalent attachment of the compound to inorganic materials.

10. Polymer film comprising at least one Compound according to any one claim of the claims 1 through 3.

11. Device **characterized in that** the polymer film according to claim 10 is located distant from an infrared laser diode emitting laser light with a wavelength between 800 nm and 1100 nm.

12. Device according to claim 11, **characterized in that** the polymer film is located between two glass slips.

13. Layer comprising at least one Compound according to any one claim of the claims 1 through 3.

## Patentansprüche

1. Nichtkristalline Verbindung, **dadurch gekennzeichnet, dass** die Verbindung eine diamantoide Kernstruktur umfasst, die mindestens ein Atom mindestens eines chemischen Elements enthält, unabhängig voneinander ausgewählt aus der Liste umfassend Si, Ge, Sn, Pb, O, S, Se, Te, wobei die Atome, die die diamantoide Kernstruktur bilden, Substituenten tragen können oder nicht, und wobei die nichtkristalline Verbindung eine Molekülstruktur gemäß Formel **I** aufweist,

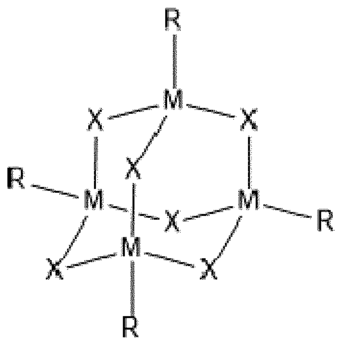

( I)

,

wobei

- die Atome M unabhängig voneinander ausgewählt sind aus der Liste umfassend Si, Ge, Sn, Pb und
- die Atome X unabhängig voneinander ausgewählt sind aus der Liste umfassend O, S, Se, Te und
- die Substituenten R unabhängig voneinander ausgewählt sind aus der Liste umfassend Phenyl, Benzyl, Styryl; aromatische polyzyklische Substituenten, zum Beispiel Naphthyl, Anthryl, Phenanthryl; heteroaromatische monocyclische Substituenten, zum Beispiel Pyridyl; heteroaromatische polyzyklische Substituenten, zum Beispiel Aza-Naphthyl, Aza-Anthryl, Aza-Phenanthryl, Diaza-Naphthyl, Diaza-Anthryl, Diaza-Phenanthryl,

wobei eine Verbindung, die entweder Ge oder Sn in Kombination mit S enthält, nicht den Substituenten p-Styryl enthält,
wobei eine Verbindung, die entweder Si oder Sn in Kombination mit S enthält, nicht den Substituenten Phenyl enthält.

2. Verbindung nach Anspruch 1, **dadurch gekennzeichnet, dass** die Kernstruktur aus anorganischen Nanokristallen des Materials gebildet wird, das mindestens ein chemisches Element enthält, ausgewählt aus der Liste umfassend Si, Ge, Sn, Pb, O, S, Se, Te, wobei die Nanokristalle an der Oberfläche mit organischen Liganden beschichtet sind.

3. Verbindung nach einem der vorhergehenden Ansprüche, **dadurch gekennzeichnet, dass** die Substituenten zufällig orientierte organische Liganden sind.

4. Verwendung einer Verbindung nach einem der vorangehenden Ansprüche in einer elektronischen Vorrichtung.

5. Verwendung nach Anspruch 4, **dadurch gekennzeichnet, dass** die elektronische Vorrichtung weißes Licht gerichtet ausstrahlt.

6. Verwendung nach Anspruch 4 oder Anspruch 5, **dadurch gekennzeichnet, dass** die elektronische Vorrichtung aus der Liste ausgewählt ist, umfassend Laserdioden, halbleitende Laserdioden, Wellenleiter, lichtemittierende Dioden (LED), organische lichtemittierende Dioden (OLED), lichtemittierende Transistoren, LED-Bildschirme, OLED-Bildschirme, Hintergrundbeleuchtungsvorrichtungen von TFT-Displays.

7. Verwendung nach einem der vorangehenden Ansprüche 4 bis 6, **dadurch gekennzeichnet, dass** die Verbindung in eine monolithische Vorrichtung integriert ist.

8. Verwendung nach einem der vorhergehenden Ansprüche 4 bis 7, **dadurch gekennzeichnet, dass** die Verbindung durch Vakuumabscheidung auf wasserstoffterminierte Siliziumeinkristalle und/oder auf GaAs aufgebracht wird, wobei die Verbindung amorphe Schichten bildet.

9. Verwendung nach einem der vorhergehenden Ansprüche 4 bis 8, **dadurch gekennzeichnet, dass** mindestens eine Art von Substituent, der an die diamandoide Kernstruktur gebunden ist, zur weiteren chemischen Modifikation und/oder kovalenten Bindung der Verbindung an anorganische Materialien verwendet wird.

10. Polymerfolie, umfassend mindestens eine Verbindung nach einem der Ansprüche 1 bis 3.

11. Vorrichtung, **dadurch gekennzeichnet, dass** die Polymerfolie nach Anspruch 10 von einer Infrarot-Laserdiode, die Laserlicht mit einer Wellenlänge zwischen 800 nm und 1100 nm emittiert, entfernt positioniert ist.

**12.** Vorrichtung nach Anspruch 11, **dadurch gekennzeichnet, dass** sich die Polymerfolie zwischen zwei Glasscheiben befindet.

**13.** Schicht, umfassend mindestens eine Verbindung nach einem der Ansprüche 1 bis 3.

**Revendications**

**1.** Composé non cristallin, **caractérisé en ce que** le composé comprend une structure de noyau diamantoïde contenant au moins un atome d'au moins un élément chimique, choisi dans la liste comprenant Si, Ge, Sn, Pb, O, S, Se, Te, les atomes formant la structure de noyau diamantoïde étant choisis indépendamment les uns des autres et pouvant porter ou non des substituants, le composé non cris-tallin présentant une structure moléculaire selon la formule **I**,

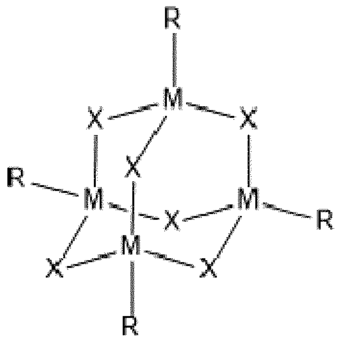

**( I)**

,

dans laquelle

- les atomes M sont choisis indépendamment les uns des autres dans la liste comprenant Si, Ge, Sn, Pb et
- les atomes X sont choisis indépendamment les uns des autres dans la liste comprenant O, S, Se, Te et
- les substituants R sont choisis indépendamment les uns des autres dans la liste comprenant Phényle, Benzyle, Styryle ; les substituants polycycliques aromatiques, par exemple Naphtyle, Anthryle, Phenanthryle ; les substituants monocycliques hétéroaromatiques,
par exemple Pyridyle ; les substituants polycycliques hétéroaromatiques, par exemple aza-Naphtyle, aza-Anthryle, aza-Phénanthryle, diaza-Naphtyle, diaza-Anthryle, diaza-Phénanthryle,

où un composé comprenant soit Ge soit Sn en combinaison avec S ne comprend pas le substituant p-Styryle,
où un composé comprenant soit Si soit Sn en combinaison avec S ne comprend pas le substituant Phényle.

**2.** Composé selon la revendication 1, **caractérisé en ce que** la structure de noyau est formée par des nanocristaux inorganiques du matériau comprenant au moins un élément chimique, choisi dans la liste comprenant Si, Ge, Sn, Pb, O, S, Se, Te, les nanocristaux étant revêtus de ligands organiques sur la surface.

**3.** Composé selon l'une quelconque des revendications précédentes, **caractérisé en ce que** les substituants sont des ligands organiques orientés de façon aléatoire.

**4.** Utilisation d'un composé selon l'une quelconque des revendications précédentes au sein d'un dispositif électronique.

**5.** Utilisation selon la revendication 4, **caractérisée en ce que** le dispositif électronique émet de manière directionnelle une lumière blanche.

**6.** Utilisation selon la revendication 4 ou la revendication 5, **caractérisée en ce que** le dispositif électronique est choisi dans la liste comprenant les diodes laser, les diodes laser semi-conductrices, les guides d'ondes, les diodes électroluminescentes (LED), les diodes électroluminescentes organiques (OLED), les transistors électroluminescents, les écrans LED, les écrans OLED, les dispositifs de rétroéclairage des écrans TFT.

**7.** Utilisation selon l'une quelconque des revendications précédentes 4 à 6, **caractérisée en ce que** le composé est intégré dans un dispositif monolithique.

**8.** Utilisation selon l'une quelconque des revendications précédentes 4 à 7, **caractérisée en ce que** le composé est appliqué par dépôt sous vide sur des monocristaux de silicium à terminaison hydrogène et/ou sur du GaAs, où le composé forme des couches amorphes.

**9.** Utilisation selon l'une quelconque des revendications précédentes 4 à 8, **caractérisée en ce qu'**au moins un type de substituant, fixé à la structure de noyau diamanoïde, est utilisé pour une modification chimique supplémentaire et/ou une fixation covalente du composé à des matériaux inorganiques.

**10.** Film polymère comprenant au moins un composé selon l'une quelconque des revendications 1 à 3.

**11.** Dispositif **caractérisé en ce que** le film polymère selon la revendication 10 est situé à distance d'une diode laser infrarouge émettant une lumière laser avec une longueur d'onde comprise entre 800 nm et 1100 nm.

**12.** Dispositif selon la revendication 11, **caractérisé en ce que** le film polymère est placé entre deux plaquettes de verre.

**13.** Couche comprenant au moins un composé selon l'une quelconque des revendications 1 à 3.

Fig. 1A

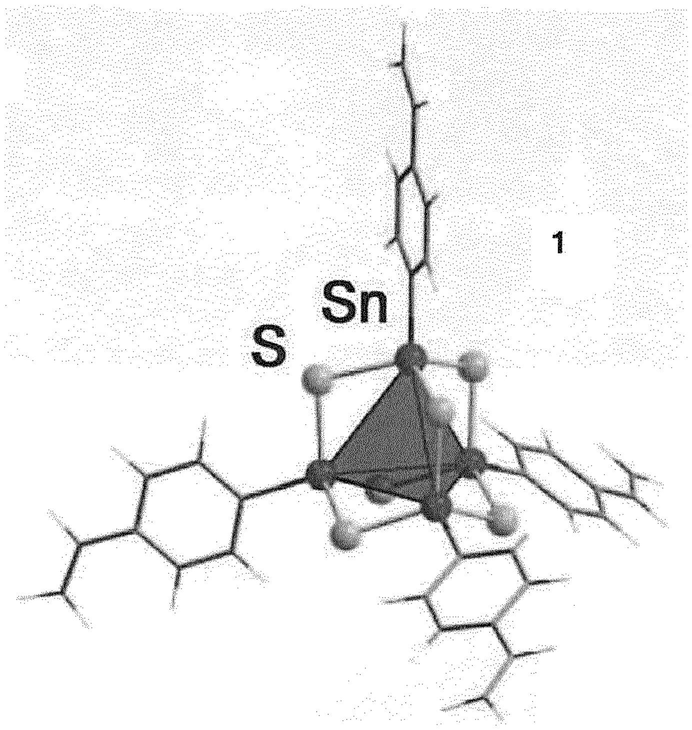

Fig. 1B

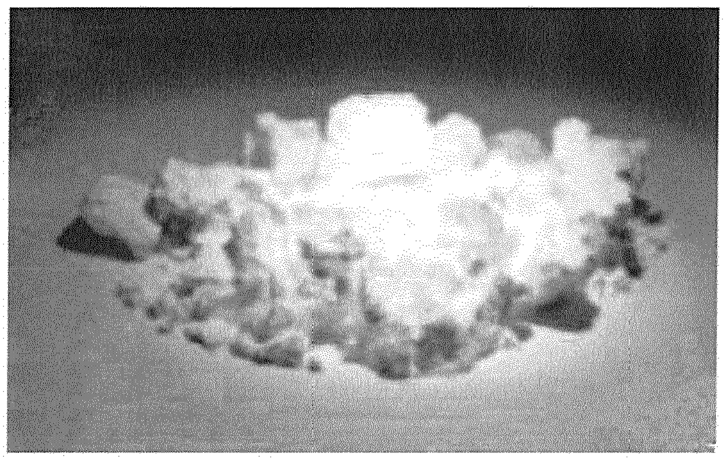

Fig. 1C

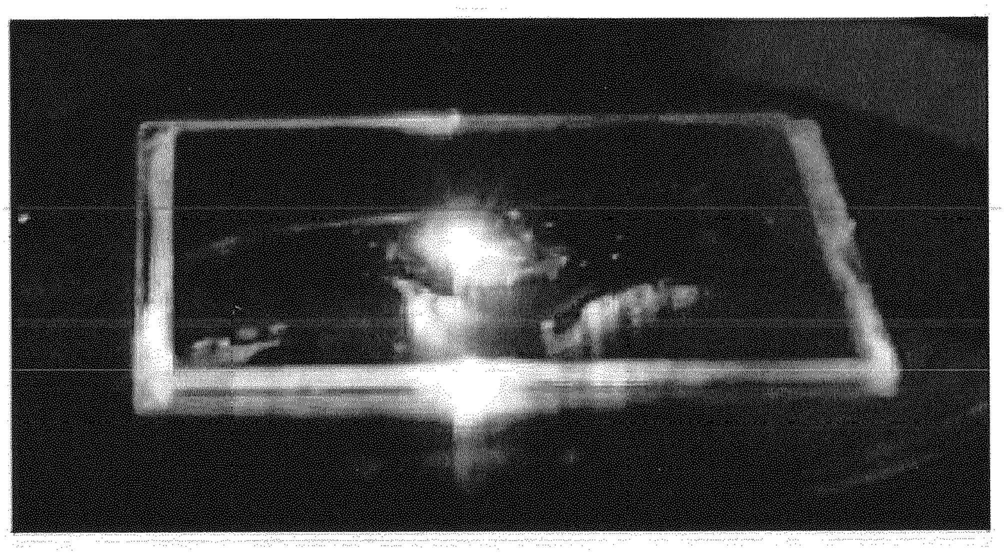

Fig. 1D

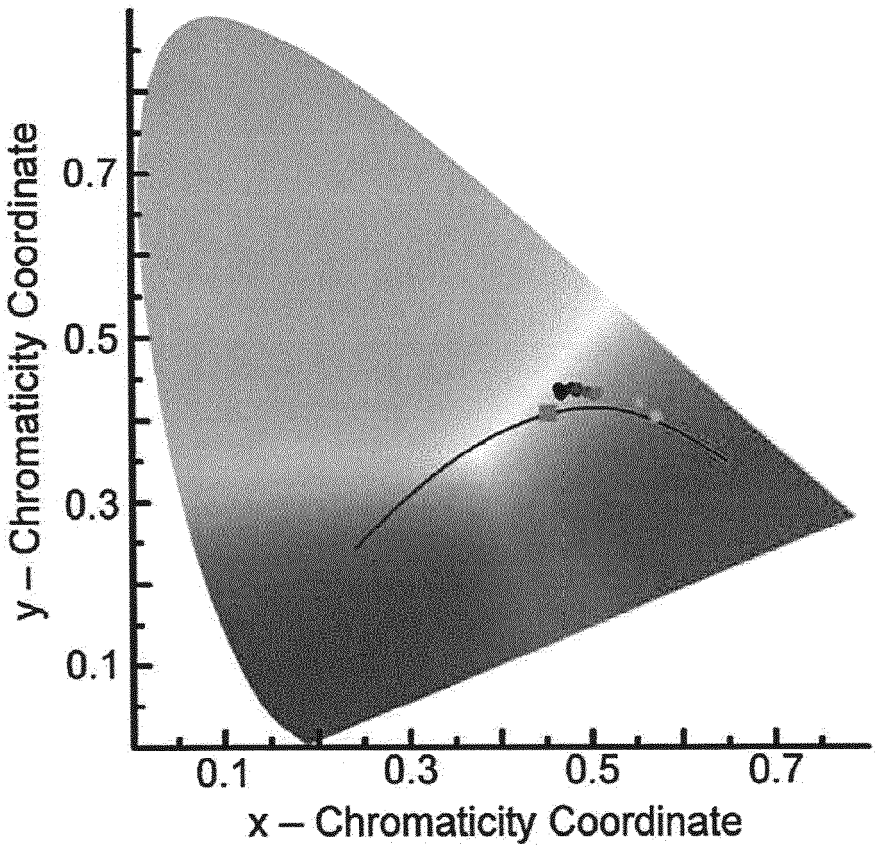
y – Chromaticity Coordinate
0.7
0.5
0.3
0.1
0.1
0.3
0.5
0.7
x – Chromaticity Coordinate

Fig. 2A

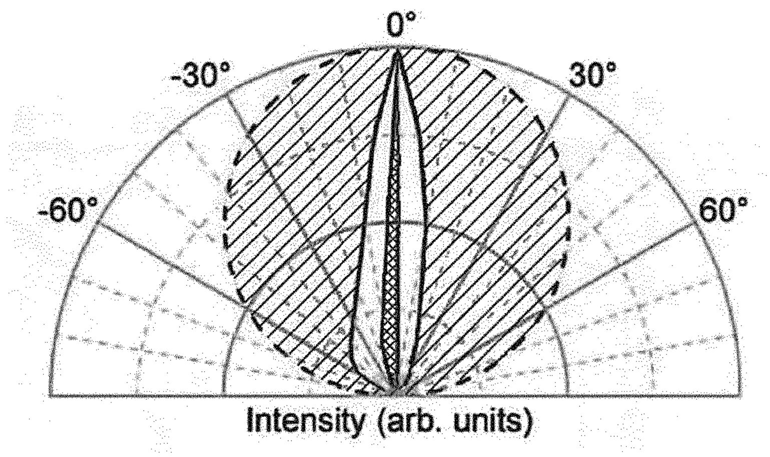


Fig. 2B

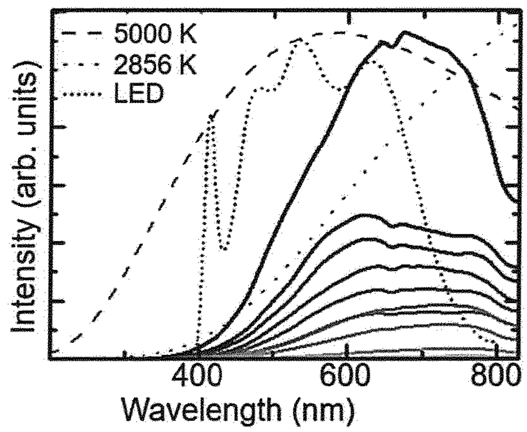


Fig. 2C

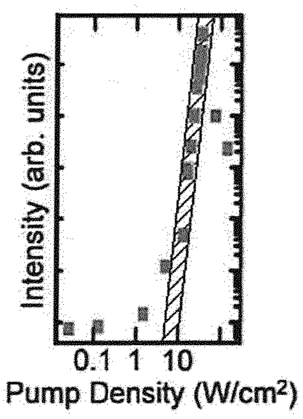

Fig. 3A

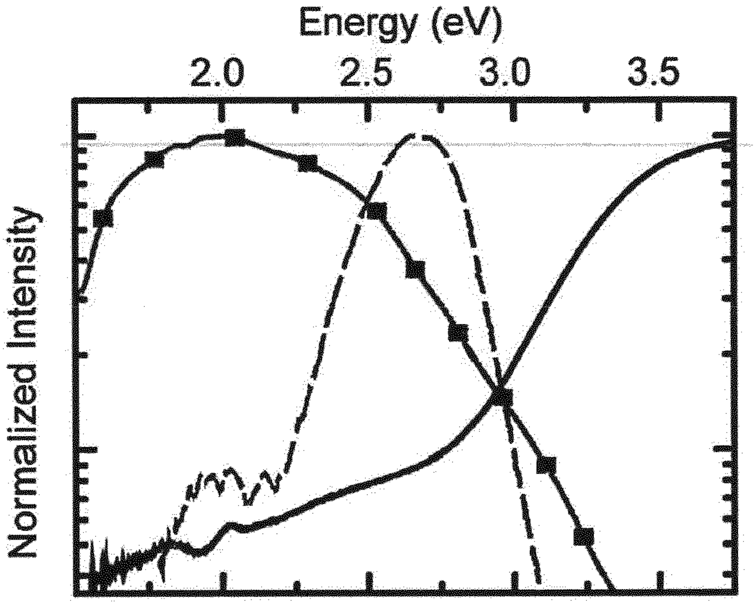
Energy (eV)
2.0
2.5
3.0
3.5
Normalized Intensity

Fig. 3B

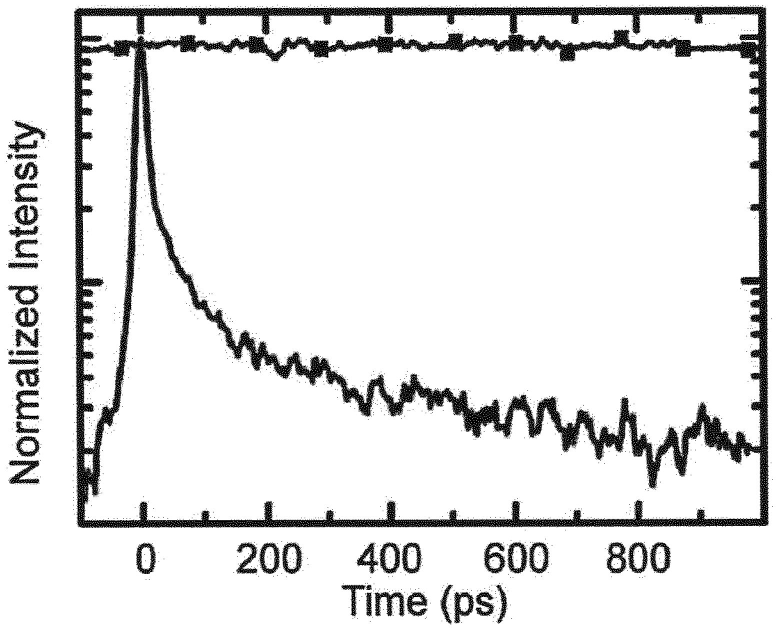
Normalized Intensity
0
200
400
600
800
Time (ps)

Fig. 3C

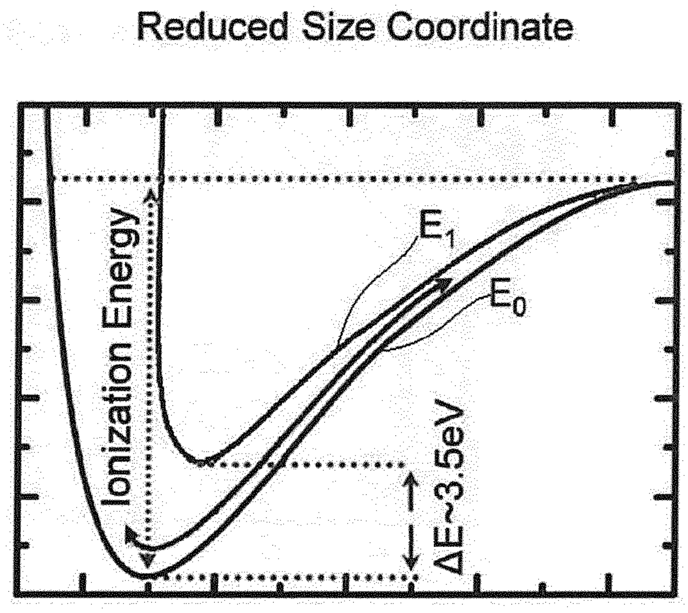
Reduced Size Coordinate
Ionization Energy
E1
E0
ΔE~3.5eV

Fig. 3D

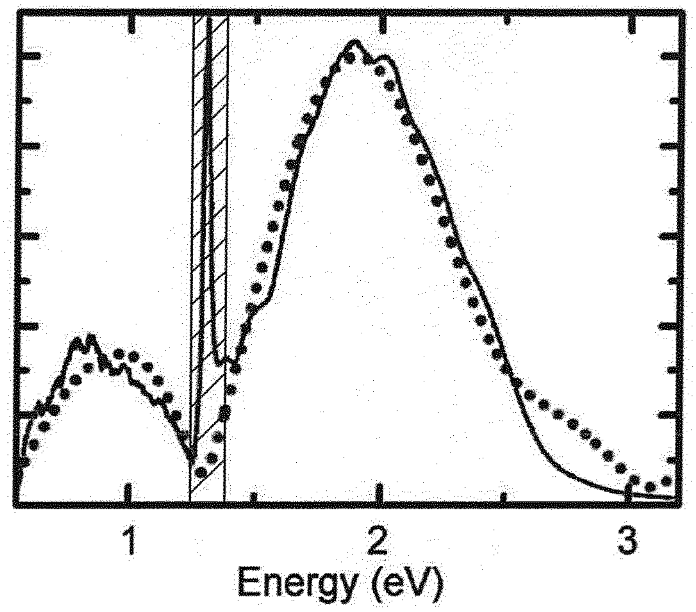
1
2
3
Energy (eV)

Fig. 4A

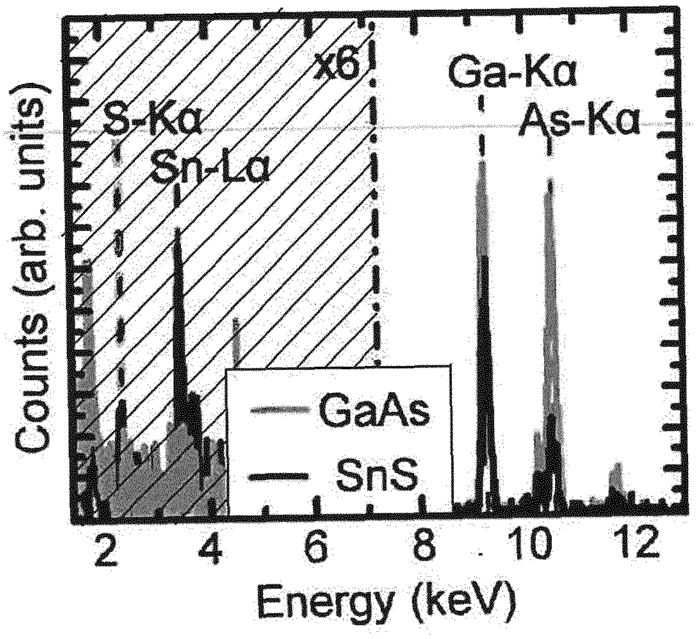
x6
Ga-Kα
As-Kα
S-Kα
Sn-Lα
GaAs
SnS
Counts (arb. units)
2
4
6
8
10
12
Energy (keV)

Fig. 4B

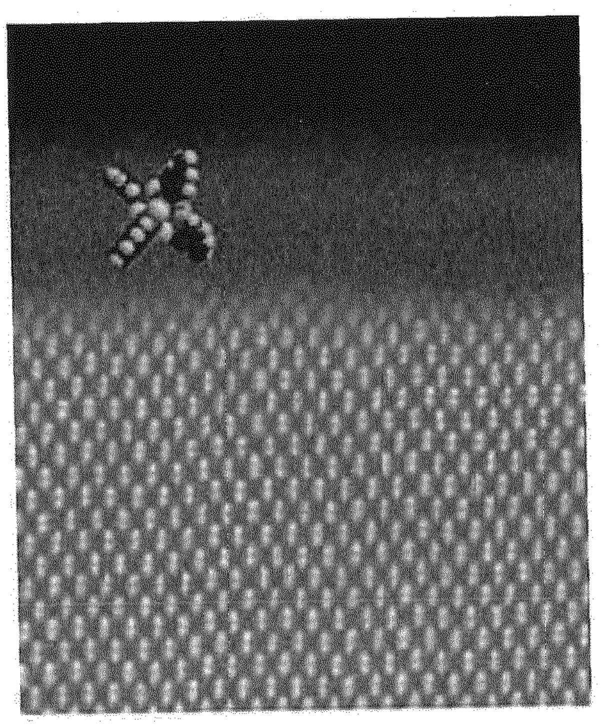

Fig. 4C

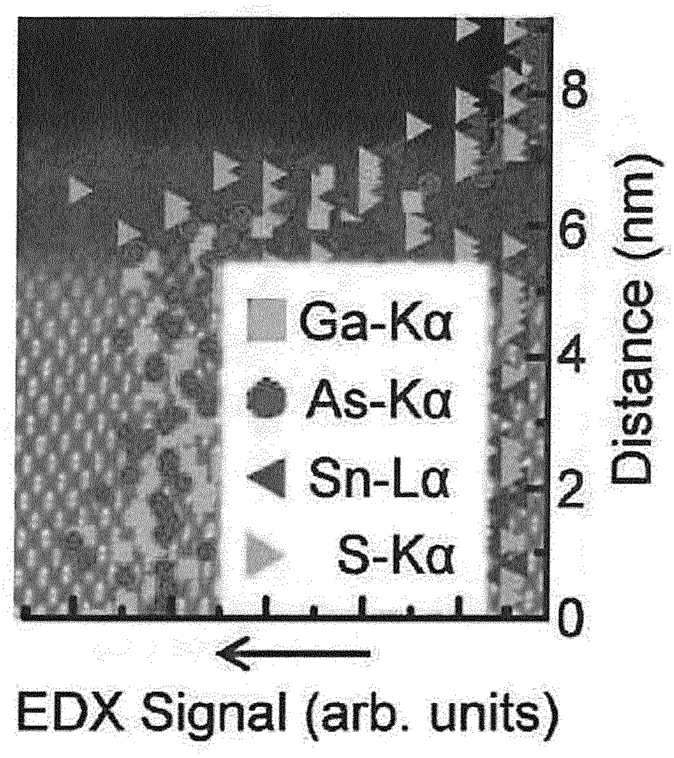
Ga-Kα
As-Kα
Sn-Lα
S-Kα
8
6
4
2
0
Distance (nm)
EDX Signal (arb. units)

Fig. 5

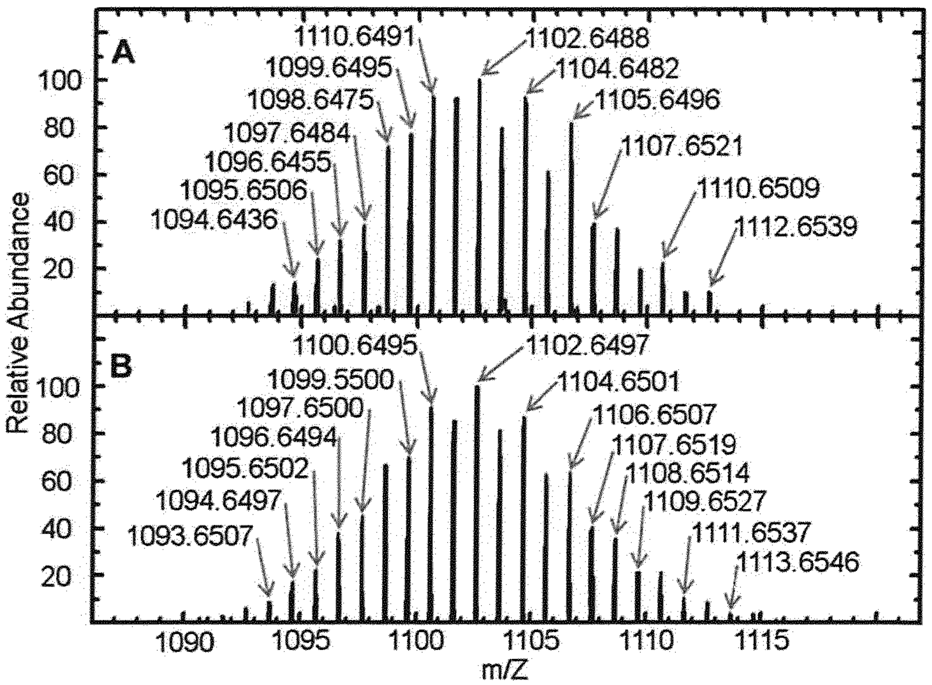
A
1110.6491
1102.6488
1099.6495
1104.6482
1098.6475
1105.6496
1097.6484
1107.6521
1096.6455
1095.6506
1110.6509
1094.6436
1112.6539
B
1100.6495
1102.6497
1099.5500
1104.6501
1097.6500
1106.6507
1096.6494
1107.6519
1095.6502
1108.6514
1094.6497
1109.6527
1093.6507
1111.6537
1113.6546
Relative Abundance
100
80
60
40
20
1090
1095
1100
1105
1110
1115
m/Z

Fig. 6

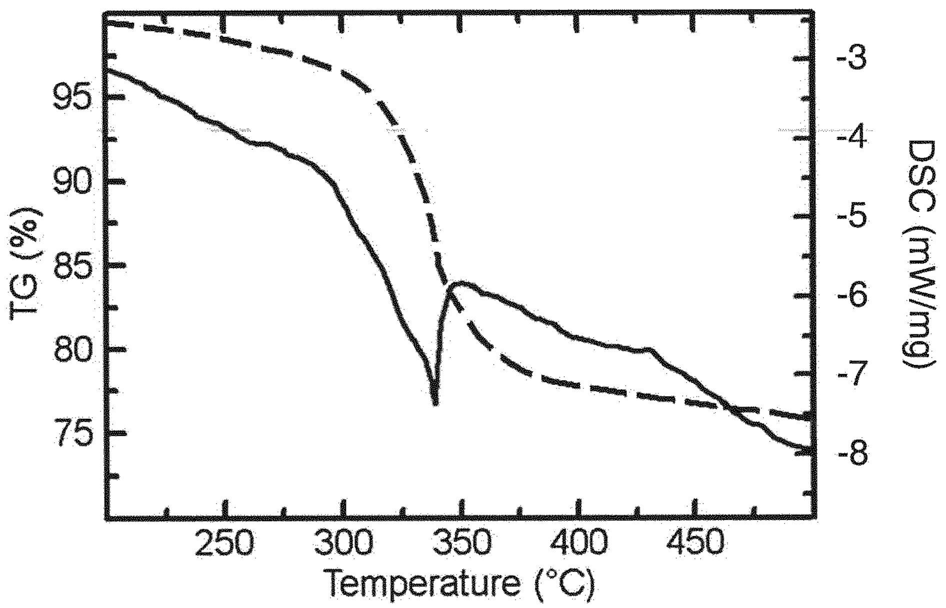

95
90
85
80
75
TG (%)
-3
-4
-5
-6
-7
-8
DSC (mW/mg)
250
300
350
400
450
Temperature (°C)


Fig. 7

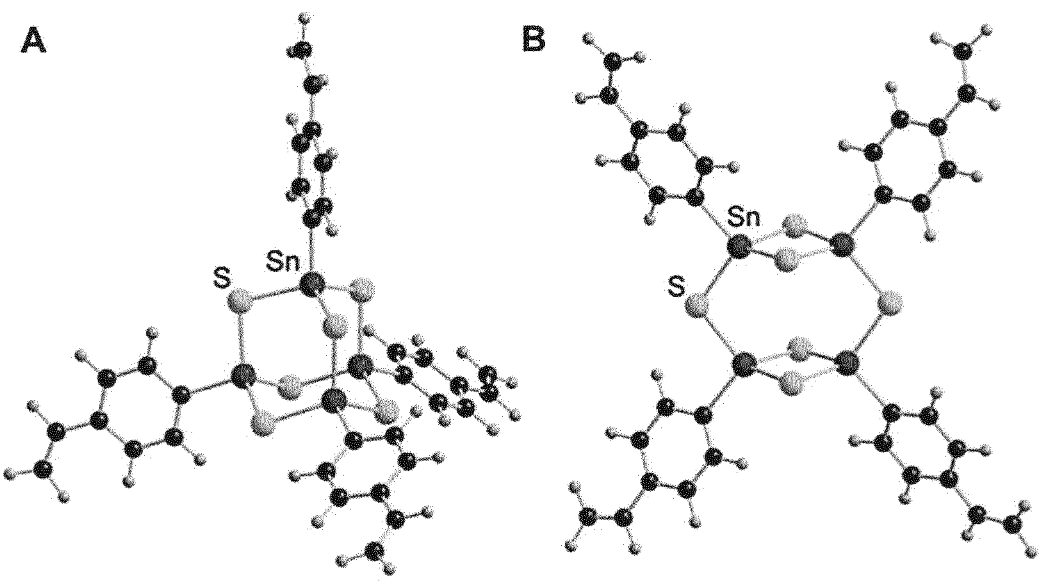

A
S
Sn
B
Sn
S

Fig. 8

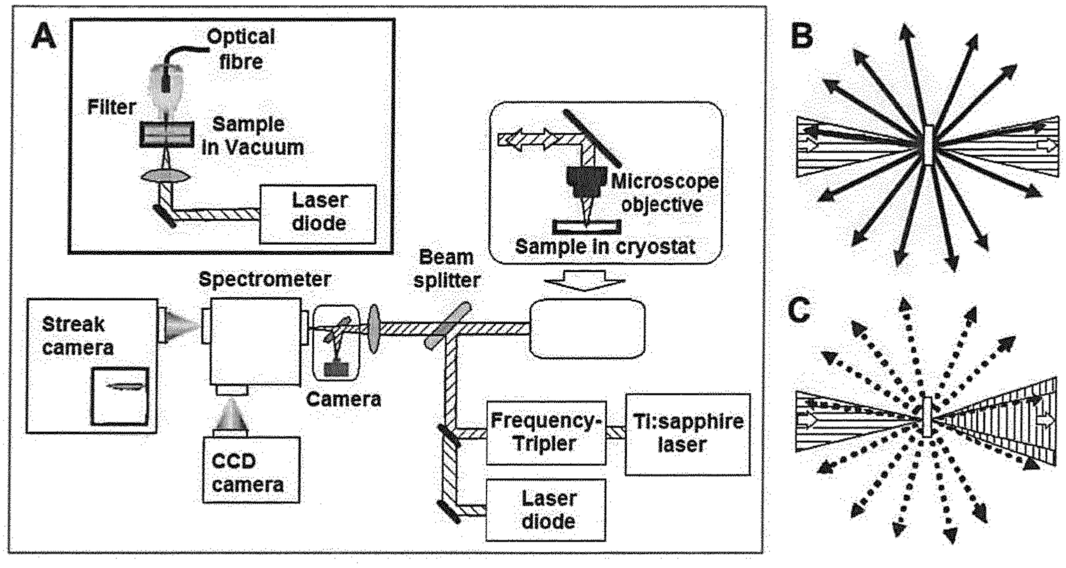
A
Optical fibre
Filter
Sample in Vacuum
Laser diode
Microscope objective
Sample in cryostat
Beam splitter
Spectrometer
Streak camera
Camera
CCD camera
Frequency-Tripler
Ti:sapphire laser
Laser diode
B
C

Fig. 9

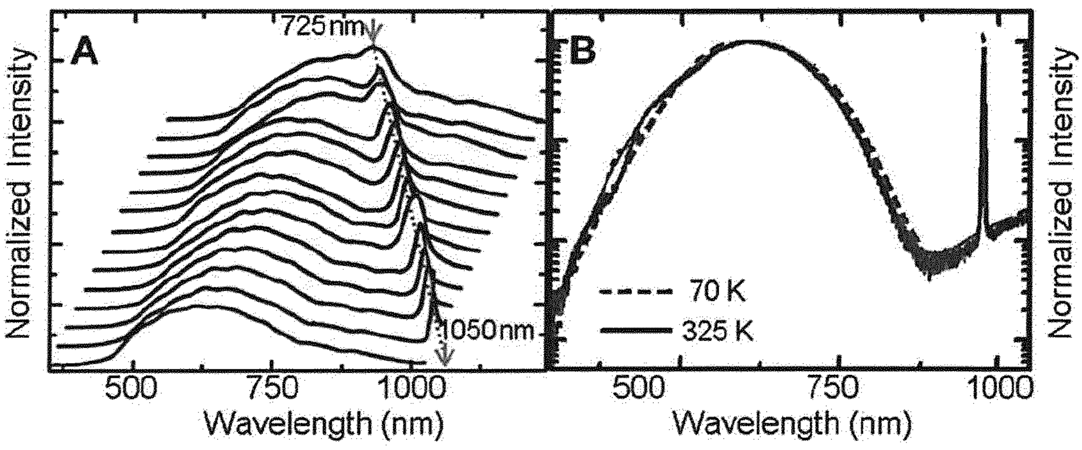
A
725nm
1050nm
Normalized Intensity
500
750
1000
Wavelength (nm)
B
70 K
325 K
Normalized Intensity
500
750
1000
Wavelength (nm)

Fig. 10

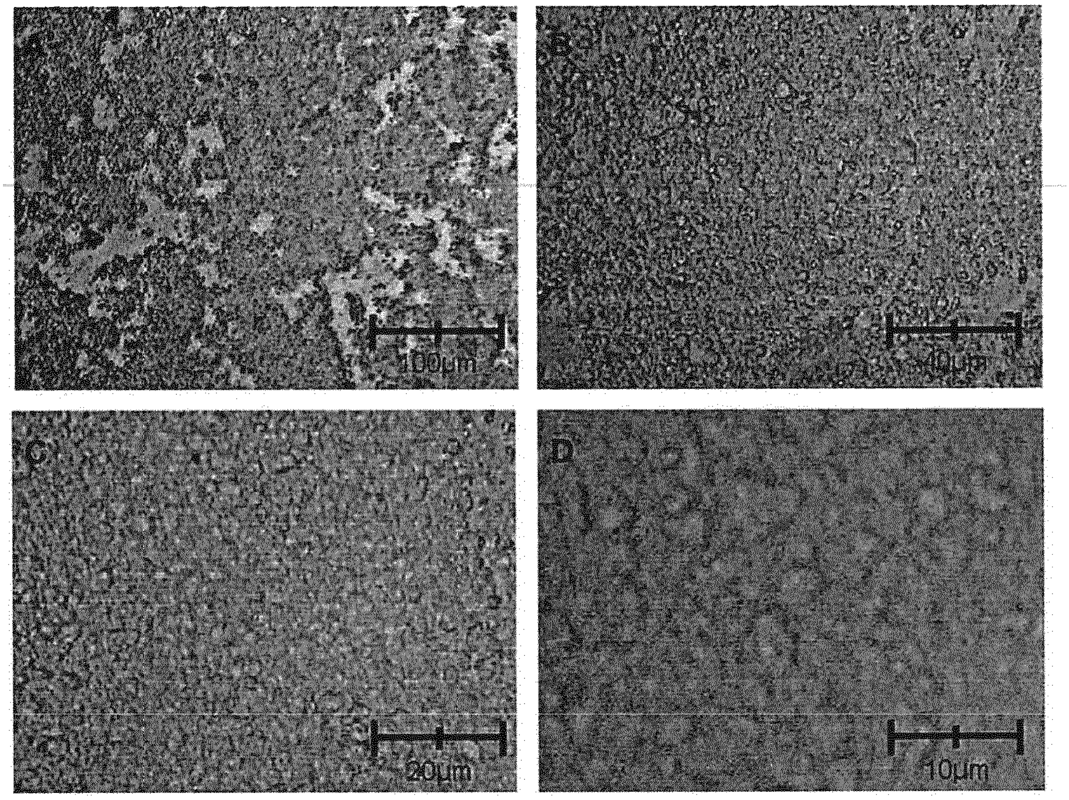
A
100μm
B
40μm
C
20μm
D
10μm

Fig. 11

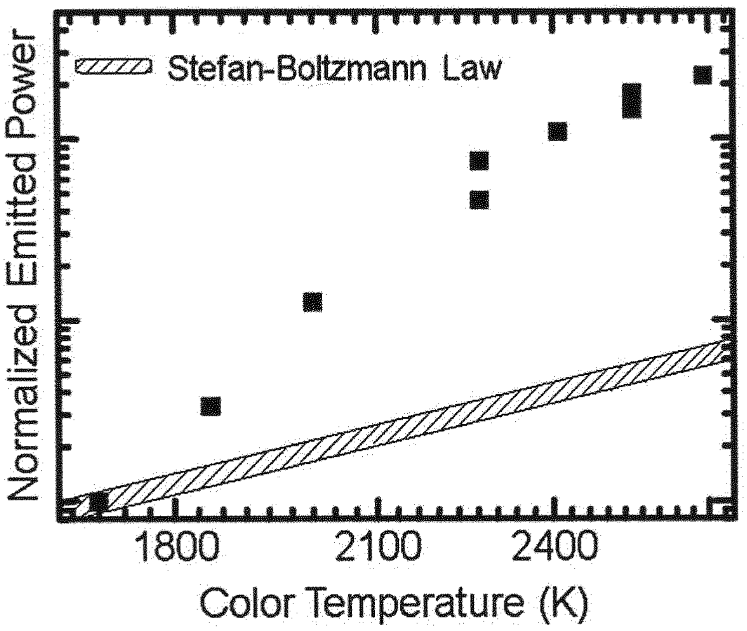
Stefan-Boltzmann Law
Normalized Emitted Power
1800
2100
2400
Color Temperature (K)

Fig. 12

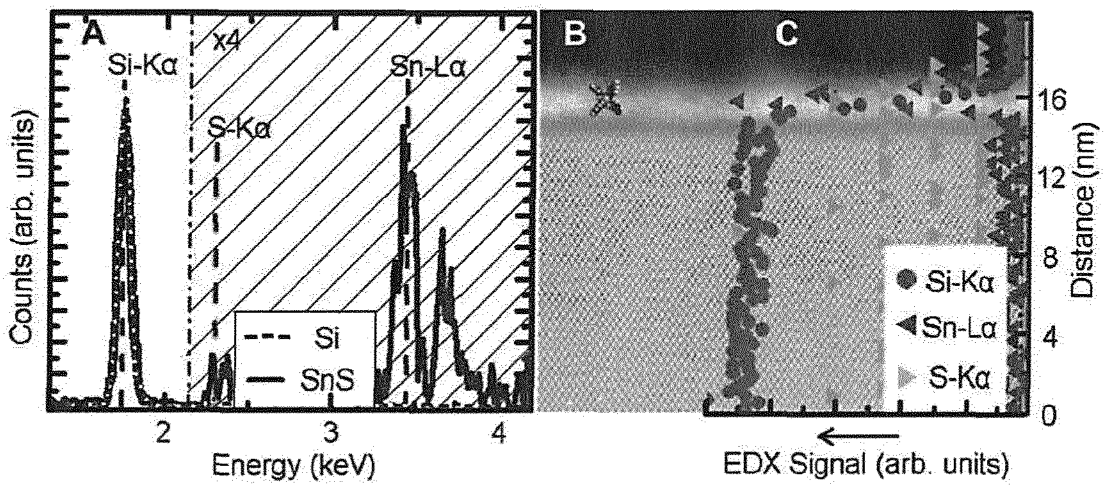


Fig. 13

Table 1

| | Hetero adamantane | Double decker |
|---|---|---|
| Energy (Hartree) | -4484.310369450 | -4484.299519561 |

Fig. 14

Table 2

| | |
|---|---|
| Sn-S | 2.4317 – 2.4452 Å |
| Sn-C | 2.1479 – 2.1484 Å |
| Sn-S-Sn | 103.610 – 104.624 Å |
| S-Sn-S | 110.585 – 112.519 Å |

Fig. 15

Table 3

| | |
|---|---|
| ω | 1.265 eV |
| $\omega_0$ | 13.46 eV |
| A | 0.05 V/nm |
| γ | 1 $10^{-6}$ Hz |
| d | 1.9 nm |

Fig. 16

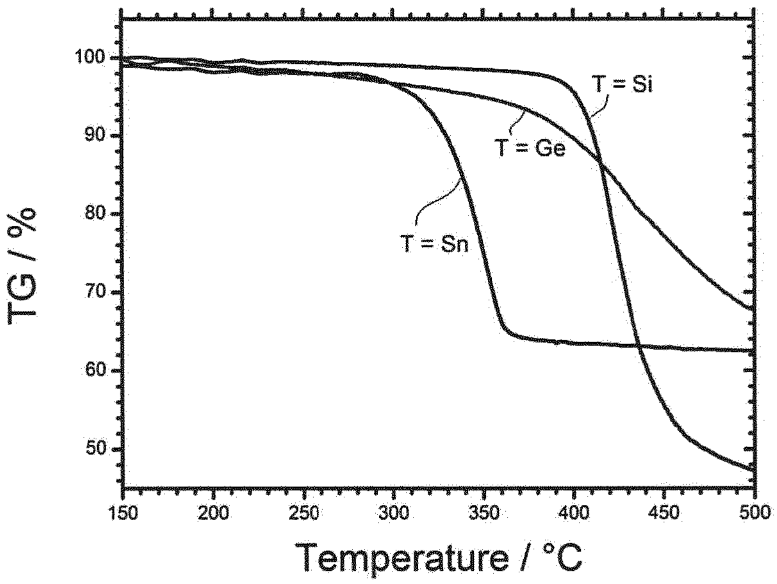

Fig. 17

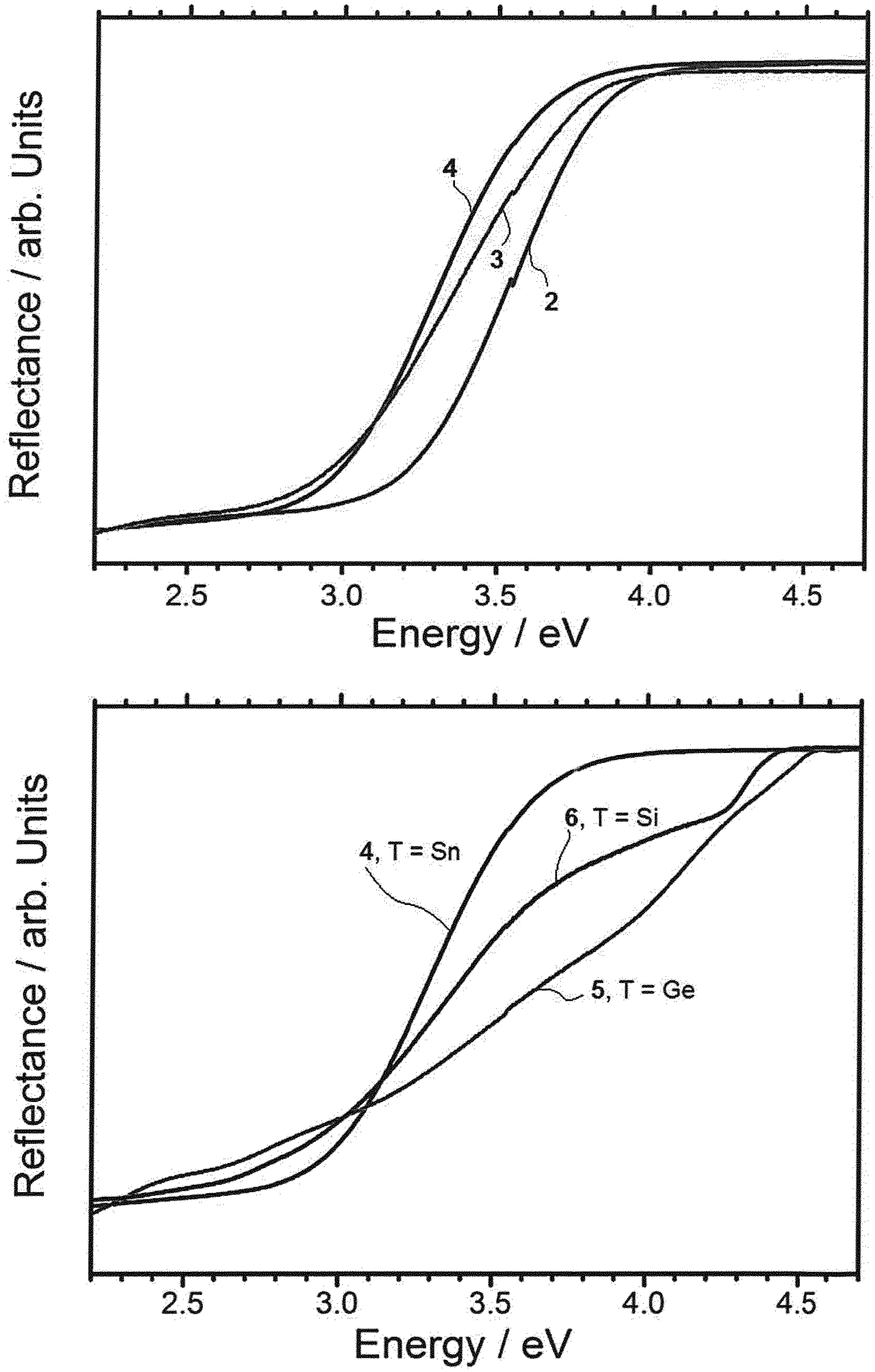
Reflectance / arb. Units
Energy / eV
2.5
3.0
3.5
4.0
4.5
4
3
2
4, T = Sn
6, T = Si
5, T = Ge

Fig. 18

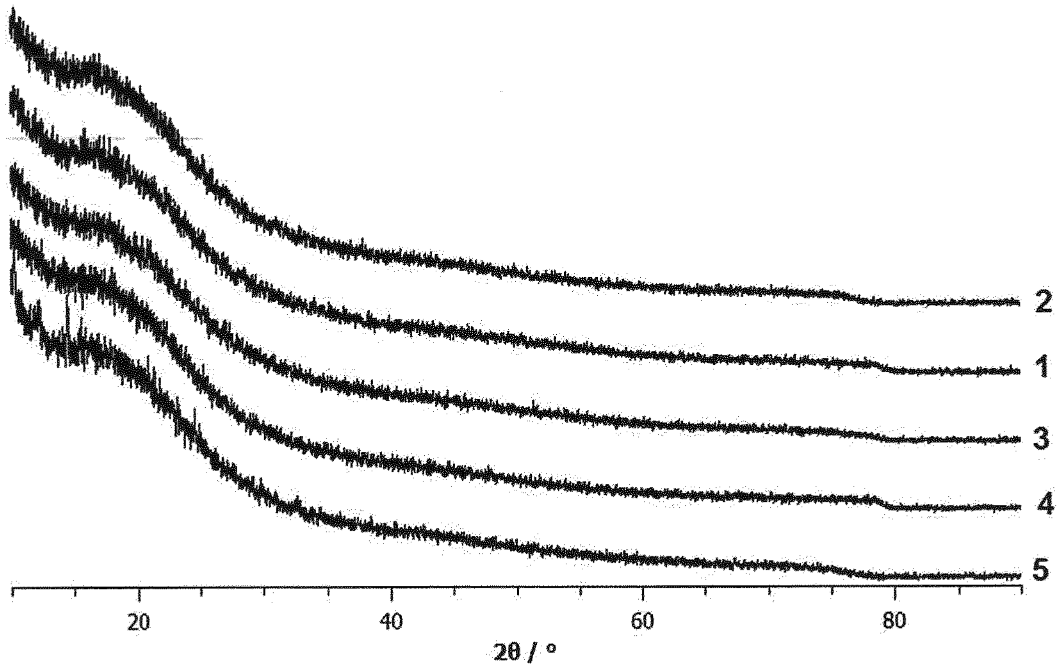
2
1
3
4
5
20
40
60
80
2θ / °

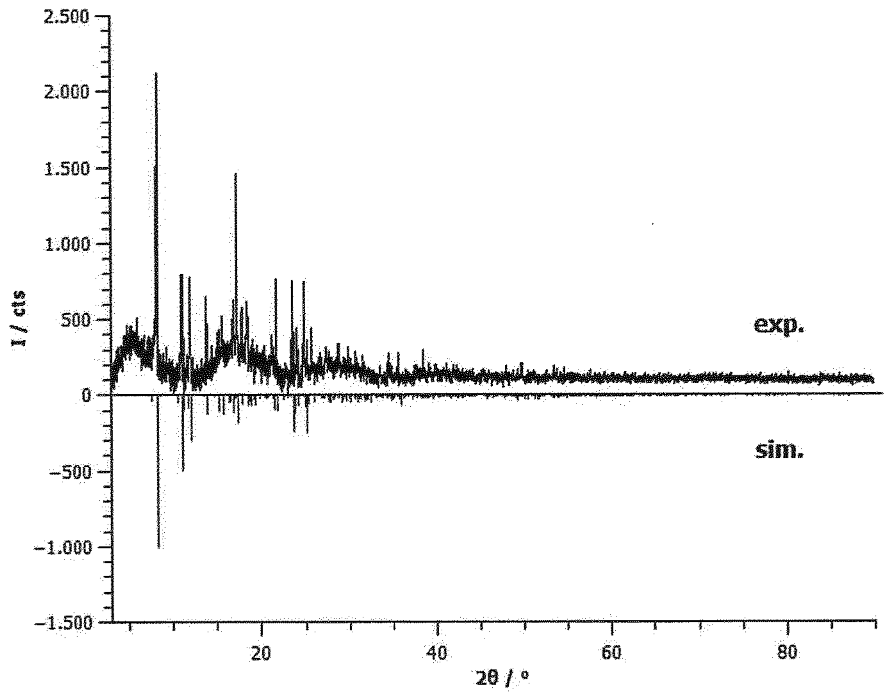
2.500
2.000
1.500
1.000
500
0
-500
-1.000
-1.500
I / cts
exp.
sim.
20
40
60
80
2θ / °

Fig. 19

Table 4

| | |
|---|---|
| Empirical formula | $C_{24}H_{20}S_6Si_4$ |
| Formula weight /g·mol$^{-1}$ | 613.12 |
| Crystal color, shape | colorless, block |
| Crystal size /mm$^3$ | 0.20 x 0.16 x 0.16 |
| Crystal system | monoclinic |
| Space group | *P21/c* |
| *a* /Å<br>*b* /Å<br>*c* /Å<br>β /° | 10.2415(3)<br>11.9566(5)<br>23.1774(8)<br>93.170(3) |
| *V* /Å$^3$ | 2833.81(17) |
| *Z* | 4 |
| $\rho_{calc}$ /g·cm$^{-3}$ | 1.437 |
| μ(MoKα) /mm$^{-1}$ | 0.666 |
| *θ range* /° | 1.76–29.17 |
| No. of measured reflections | 26535 |
| No. of independent reflections, *R*(int) | 7616, 0.0424 |
| No. of independent reflections ($I > 2\sigma(I)$) | 5888 |
| Parameters | 307 |
| Restraints | 0 |
| $R_1$ ($I > 2\sigma(I)$) | 0.0277 |
| $wR_2$ (all data) | 0.0688 |
| *GOF (all data)* | 0.925 |
| Max. peak/hole /e$^-$·Å$^{-3}$ | 0.561 / –0.225 |
| Absorption correction type | none |

Fig. 20

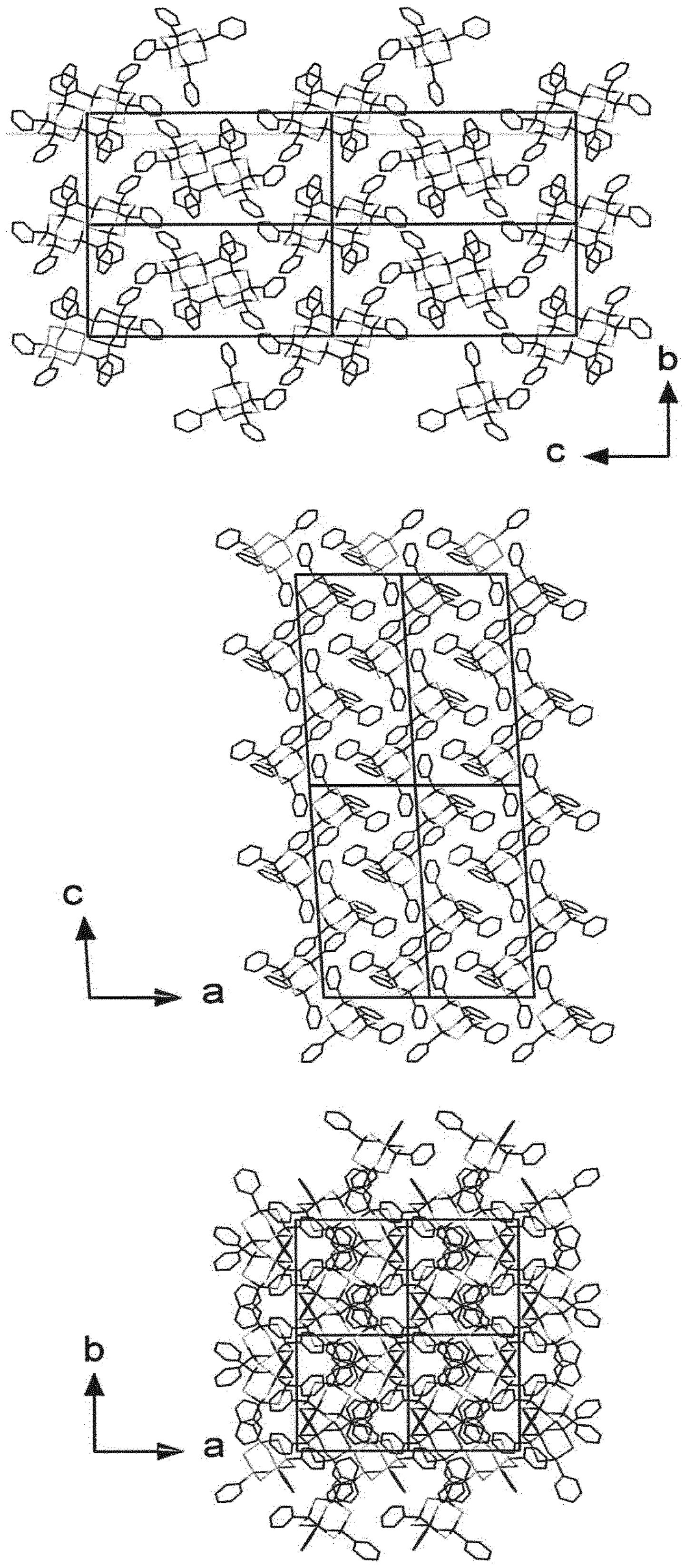

Fig. 21

Table 5

| Compound | $\Delta E_{AD-DD}$ / kJ |
|---|---|
| [$(MeSn)_4S_6$] (**2**) | –36.4 |
| [$(NpSn)_4S_6$] (**3**) | –19.2 |
| [$(StySn)_4S_6$] (**1**) | –28.5 |
| [$(PhSn)_4S_6$] (**4**) | –28.2 |
| [$(PhGe)_4S_6$] (**5**) | –30.4 |
| [$(PhSi)_4S_6$] (**6**) | –20.7 |

Fig. 22

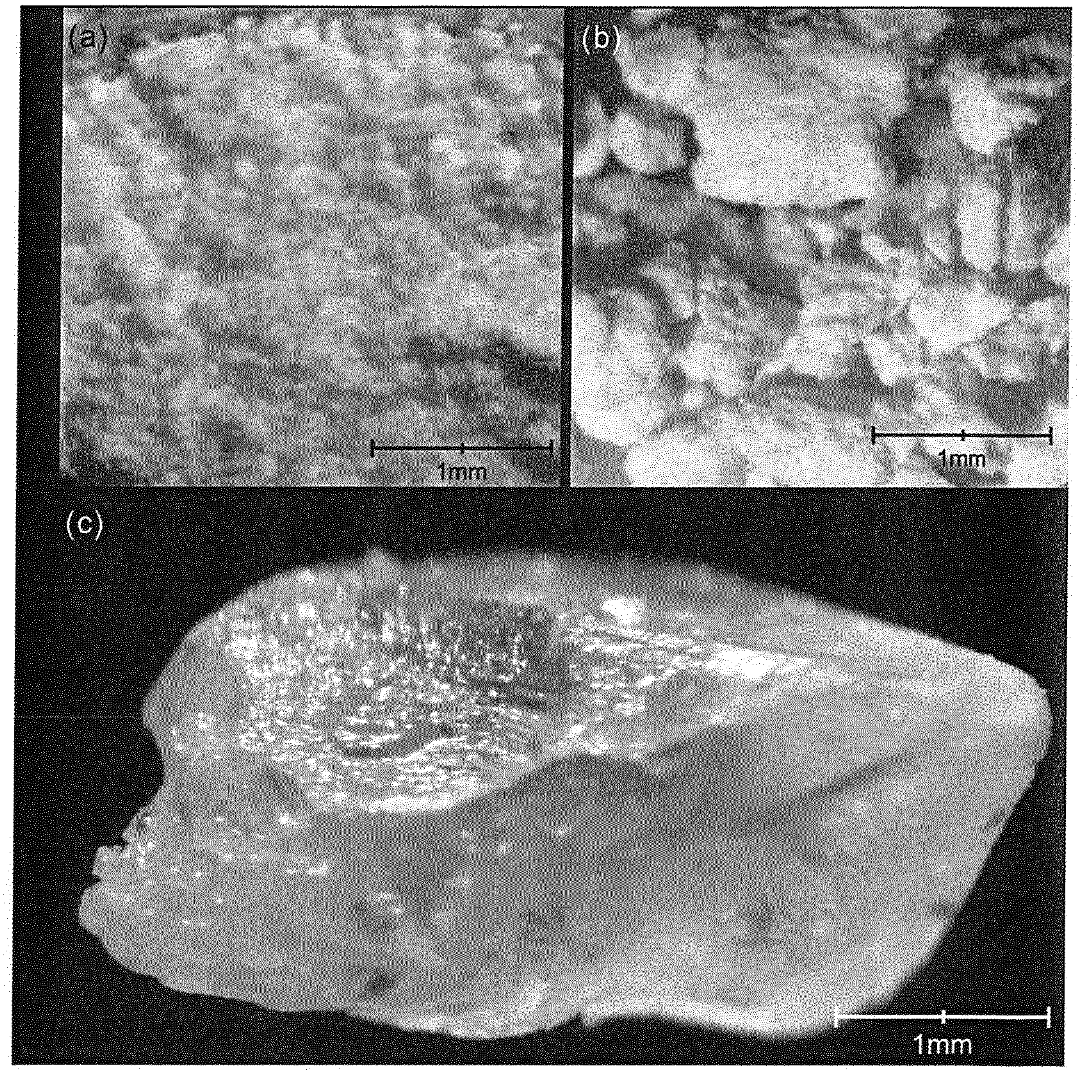

Fig. 23

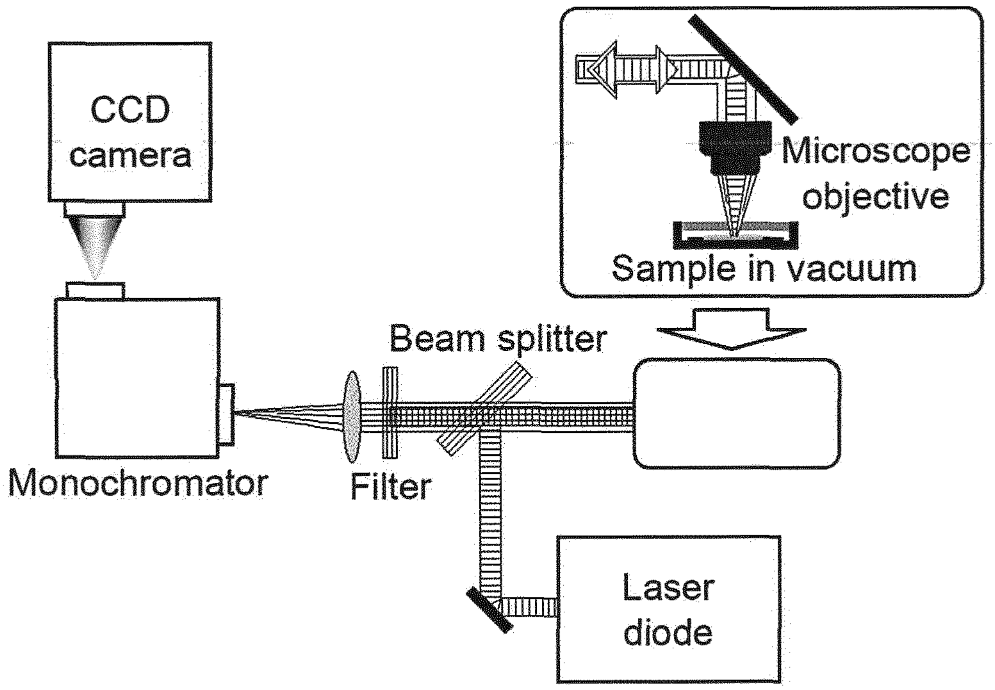
CCD camera
Microscope objective
Sample in vacuum
Beam splitter
Monochromator
Filter
Laser diode

Fig. 24

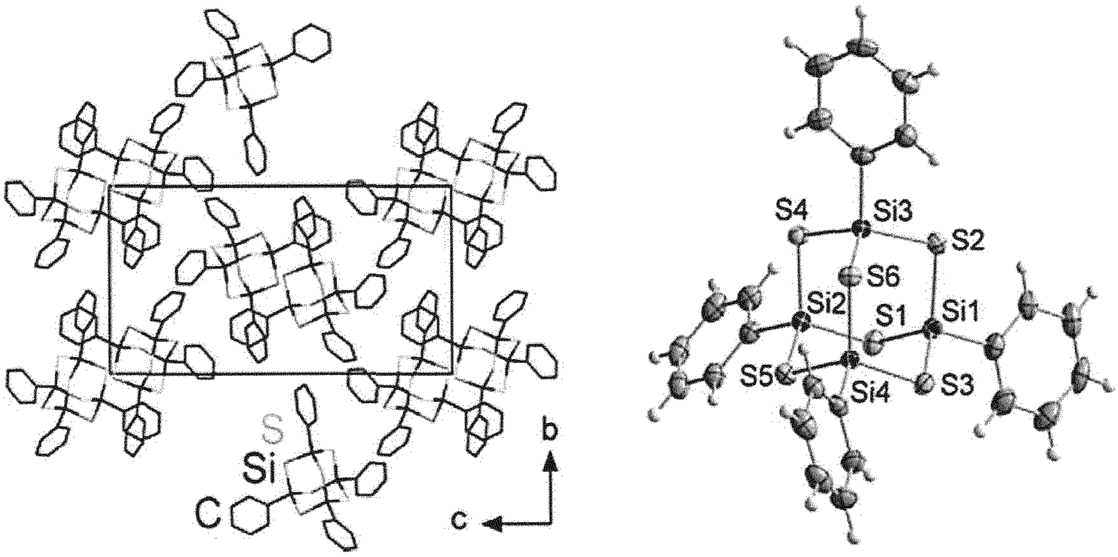
S
Si
C
b
c
S4
Si3
S2
S6
Si2
S1
Si1
S5
Si4
S3

Fig. 25

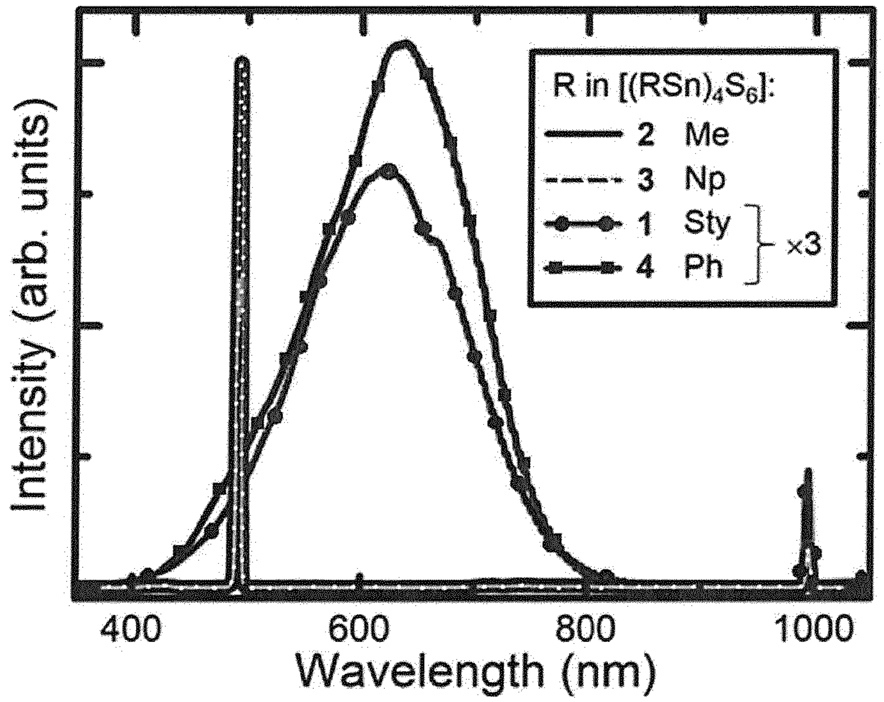
R in [(RSn)4S6]:
2 Me
3 Np
1 Sty
4 Ph
×3
Intensity (arb. units)
400
600
800
1000
Wavelength (nm)

Fig. 26

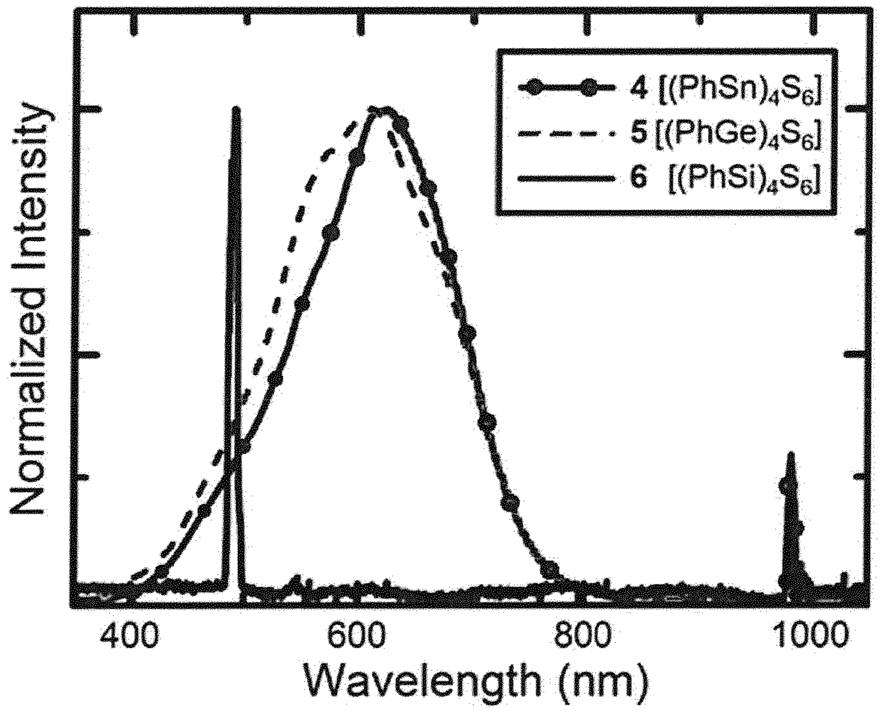
4 [(PhSn)4S6]
5 [(PhGe)4S6]
6 [(PhSi)4S6]
Normalized Intensity
400
600
800
1000
Wavelength (nm)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2009099568 A1